(19) 

Europäisches
Patentamt
European
Patent Office
Office européen
des brevets

(11) **EP 2 360 662 A1**

(12) **EUROPEAN PATENT APPLICATION**
published in accordance with Art. 153(4) EPC

(43) Date of publication:
**24.08.2011 Bulletin 2011/34**

(51) Int Cl.:
*G09F 9/40* (2006.01)  *G02F 1/1333* (2006.01)
*G02F 1/1335* (2006.01)  *G09F 9/00* (2006.01)
*H04N 5/66* (2006.01)

(21) Application number: **09825924.5**

(22) Date of filing: **13.11.2009**

(86) International application number:
**PCT/JP2009/006074**

(87) International publication number:
**WO 2010/055671 (20.05.2010 Gazette 2010/20)**

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**

(30) Priority: **17.11.2008 JP 2008293878**

(71) Applicant: **Sharp Kabushiki Kaisha
Osaka-shi, Osaka 545-8522 (JP)**

(72) Inventor: **WATANABE, Hisashi
Osaka-shi
Osaka 545-8522 (JP)**

(74) Representative: **Müller-Boré & Partner
Patentanwälte
Grafinger Straße 2
81671 München (DE)**

(54) **DISPLAY DEVICE**

(57)   A direct-viewing type display device **100a** includes a display panel **10** having a display region **31** and a frame region **30** formed outside the display region; and a light guide element **20** having an incident face **21**, an outgoing face **22**, and a plurality of light guide portions formed between the incident face **21** and the outgoing face **22**. The plurality of light guide portions include a transparent portion; the transparent portion has a metal portion provided in at least a part of a side face thereof; the incident face **21** of the light guide element **20** is disposed to overlap a part **32** of a peripheral display region adjoining the frame region **30** of the display panel **10** along a first axis **J1** and to be parallel to a surface of the display panel **10**; and a distance between the outgoing face **22** and the incident face **21** of the light guide element **20** increases along the first axis **J1** from the part **32** of the peripheral display region toward the frame region **30**. According to the present invention, a direct-viewing type display device having a frame region of the display panel obscured or a joint between tiled display panels obscured is provided with a simpler and lightweight structure than the conventional device.

FIG.1

EP 2 360 662 A1

**Description**

**TECHNICAL FIELD**

The present invention relates to a display device, and in particular to a direct-viewing type display device.

**BACKGROUND ART**

In recent years, there is a strong desire for an increase in the size of TVs and display devices for displaying information. Representative examples of large-sized display devices are display devices in which self-light-emitting elements such as light-emitting diodes (LEDs) are arranged in a matrix and projection-type display devices. However, these devices are disadvantageous in terms of image quality. Therefore, a further increase in the size of direct-viewing type liquid crystal display devices (LCDs) and plasma display devices (PDPs), which are capable of providing high quality image display, is now desired.

Since a direct-viewing type liquid crystal display device or a plasma display device is basically formed on a glass substrate, the size of a screen thereof depends on the size of the substrate. Currently, the largest of glass substrates (mother substrates) that are used for producing liquid crystal display devices is of the eighth generation (2200 mm x 2400 mm), and liquid crystal display devices having a diagonal of about 100 inches are produced by this type of substrate. The substrates that are usable for mass production are more and more increased in size, but the rate of increase is low. It is difficult to immediately provide display devices of a large area size that are desired by the current market.

Therefore, as a method for increasing the size of screen of a display device, it has been attempted to arrange a plurality of display devices (which may be referred to as "tiling") to realize a large-screen display device in a pseudo manner. However, the tiling technique induces a problem that a joint between the plurality of display devices is visible. This problem will be described regarding a liquid crystal display device as an example.

A liquid crystal display device mainly includes a liquid crystal display panel, a backlight device, circuits for supplying various electrical signals to the liquid crystal display device, a power supply, and a housing for accommodating theses elements. The liquid crystal display panel mainly includes a pair of glass substrates and a liquid crystal layer provided therebetween. On one of the pair of glass substrates, for example, pixel electrodes are formed in a matrix, and TFTs, bus lines, driving circuits for supplying signals thereto and the like are provided. On the other glass substrate, a color filter layer and a counter electrode are provided. The liquid crystal display panel has a display region in which a plurality of pixels are arrayed, and a frame region surrounding the display region. In the frame region, a sealing portion for allowing the pair of substrates to face each other and also sealing and retaining the liquid crystal layer, a driving circuit-mounted portion for driving the pixels and the like are provided.

As described above, the liquid crystal display panel includes the frame region which does not contribute to display. Therefore, when a large screen is formed by arraying a plurality of liquid crystal display panels, the image has joints. This problem is not limited to liquid crystal display devices, but is common among direct-viewing type display devices including PDPs, organic EL display devices, electrophoretic display devices and the like.

Patent Document 1 discloses a structure which includes an optical fiber face plate covering the entire surface of the display panel, and provides jointless display by allowing light going out from the display region to be guided to a non-display region by the optical fiber face plate.

Patent Document 2 discloses a structure which includes an optical fiber face plate complex provided on the entire surface of the display panel, and provides jointless display by allowing light going out from the display region to be guided to a non-display region by the optical fiber face plate.

Patent Document 3 discloses a structure including optical compensation means, on substantially the entire surface of the display panel, formed of a multitude of inclined thin films and a transparent material filling a gap between the inclined thin films, and provides jointless display by allowing light to be guided to a non-display region by the optical compensation means. As the inclined thin films, metal films or films of a resin (e.g., transparent resin such as an acrylic resin, polycarbonate or the like) are used.

**CITATION LIST**

**PATENT LITERATURE**

[Patent Document 1] Japanese Laid-Open Patent Publication No. 7-128652
[Patent Document 2] Japanese Laid-Open Patent Publication No. 2000-56713
[Patent Document 3] Japanese Laid-Open Patent Publication No. 2001-5414

## SUMMARY OF INVENTION

### TECHNICAL PROBLEM

An optical fiber face plate is an aggregate of optical fibers, and so a larger plate is more difficult and highly costly to produce. The conventional techniques described in Patent Document 1 and Patent Document 2 require an optical fiber face plate covering substantially the entire surface of the display panel, and thus are not practical from the standpoint of the production method and cost, particularly for large-sized display devices.

The technique described in Patent Document 3 is different from the techniques described in Patent Documents 1 and 2 in that the former uses the optical compensation means formed of a multitude of inclined thin films and a transparent material filling a gap between the inclined thin films, instead of an optical fiber face plate. However, the technique described in Patent Document 3 still requires the optical compensation means covering substantially the entire surface of the display panel, and thus involves similar problems to those of the techniques described in Patent Document 1 and Patent Document 2.

Patent Document 2 states that a parallel plate (an optical fiber face plate having an incident face and an outgoing face which are parallel to each other) to be disposed in the display region is omissible. However, when the parallel plate is omitted, an end face portion of a block-like optical fiber face plate (having a rectangular cross-section) disposed at an edge portion of the display region forms a stepped portion in the display region. This renders the image discontinuous and lowers display quality.

Regarding the method for producing the optical compensation means, Patent Document 3 describes that inclined thin films are set and fixed to an outer frame as inclined at a prescribed angle; a liquid-like transparent substance is injected into a gap between the inclined thin films so as to fill the gap; and then the liquid-like transparent substance is cured.

In order to prevent an image displayed by a display device from being blurred, the inclined thin films need to be produced at a pitch equal to or smaller than the pitch of the pixels. In order to produce the inclined thin films with a gap which is to be filled with the liquid-like substance, it is conceivable to form ribs having a super high aspect ratio by, for example, photolithography. However, this is very difficult.

It is also difficult to produce inclined thin films inclined at a large angle (e.g., inclined at an angle of 30° or greater from the direction normal with respect to the display plane), and it is difficult to fill the gap between the inclined thin films inclined at such a large angle with a liquid-like substance with no bubbles.

These problems become more serious as the screen of the display device becomes larger. Such optical compensation means is low in mass productivity and highly costly.

The inclined thin films need to be produced to have a certain level of thickness in order to be self-standing. However, the thickness needs to be sufficiently smaller than the pitch of the inclined thin films; otherwise, the transmittance of the light guide element is decreased and thus the luminance of the display device is decreased. For example, where the thickness of each of the inclined thin films is 0.5 mm and the pitch thereof is 1 mm, the transmittance is 50% (in actuality, light is absorbed by the transparent substance provided between the inclined thin films, and so the transmittance is still lower). In an actual display device, the pitch of the pixels is smaller, and so the pitch of the inclined thin films needs to be smaller, which further decreases the transmittance.

The present invention made for solving the above-described problems has an object of providing a direct-viewing type display device having a frame region of a display panel obscured or having a joint between tiled display panels being obscured, which can be produced more easily and at lower cost than the conventional device.

### SOLUTION TO PROBLEM

A direct-viewing type display device according to the present invention includes at least one display panel having a display region and a frame region formed outside the display region; and at least one light guide element having an incident face, an outgoing face, and a plurality of light guide portions formed between the incident face and the outgoing face. The plurality of light guide portions include at least one transparent portion; the at least one transparent portion has a metal portion provided in at least a part of a side face thereof; the incident face of the at least one light guide element is disposed so as to overlap a part of a peripheral display region adjoining the frame region of the at least one display panel along a first axis and so as to be parallel to a surface of the at least one display panel; and a distance between the outgoing face and the incident face of the at least one light guide element increases along the first axis from the part of the peripheral display region toward the frame region.

In an embodiment, the at least one light guide element has a laminate in which a plurality of transparent layers and a plurality of metal layers are stacked.

In an embodiment, the plurality of metal layers include a metal layer having a thickness of 100 nm or greater and 5 $\mu$m or less.

In an embodiment, the plurality of metal layers include a metal layer having a thickness of 100 nm or greater and 1 $\mu$m or less.

In an embodiment, the at least one transparent portion is generally cylindrical, and the side face thereof is covered with the metal portion.

In an embodiment, the at least one display panel includes first and second display panels adjoining each other; a side face of the second display panel overlaps the frame region of the first display panel such that an angle made by a viewer-side surface of the first display panel and a viewer-side surface of the second display panel is greater than 0° and less than 180°; the at least one light guide element includes first and second light guide elements; and a volume of the first light guide element is larger than a volume of the second light guide element.

In an embodiment, an end, on the side of the second display panel, of the outgoing face of the first light guide element abuts on an end, on the side of the first display panel, of the outgoing face of the second light guide element.

In an embodiment, the outgoing face of the first light guide element is parallel to the outgoing face of the second light guide element.

In an embodiment, the first light guide element and the second light guide element have a triangular prism shape.

In an embodiment, the first light guide element and the second light guide element have an isosceles triangular prism shape.

In an embodiment, where the angle made by the viewer-side surface of the first display panel and the viewer-side surface of the second display panel is θ, the first light guide element and the second light guide element have an isosceles triangular prism shape having a vertex angle of θ/2.

In an embodiment, the outgoing faces of the first light guide element and the second light guide element are cylindrical surfaces.

In an embodiment, the display device according to the present invention further includes a backlight device on the side opposite from the viewer-side surface of the second display panel. A side face, on the side of the first display panel, of the backlight device is parallel to the viewer-side surface of the first display panel and overlaps the frame region of the first display panel.

In an embodiment, a light-diffusing layer is provided on the outgoing face of the first light guide element or the outgoing face of the second light guide element.

In an embodiment, the at least one display panel includes at least three display panels; and the at least three display panels are disposed in an annular shape.

## ADVANTAGEOUS EFFECTS OF INVENTION

According to the present invention, a direct-viewing type display device having a frame region of a display panel obscured or having a joint between tiled display panels being obscured, which can be produced more easily or at lower cost than the conventional device, can be provided.

## BRIEF DESCRIPTION OF DRAWINGS

[FIG. 1] FIG. **1** is a schematic cross-sectional view of a liquid crystal display device **100a** according to an embodiment of the present invention.

[FIG. 2] FIG. **2** is a schematic cross-sectional view of an end of the liquid crystal display device **100a.**

[FIG. 3] FIG. **3** is a schematic perspective view of a liquid crystal display device **100A** including a plurality of liquid crystal display devices **100a** arranged in a line.

[FIG. 4] FIG. **4** is a schematic perspective view showing a structure of a sheet laminate **90** usable as a light guide element of a display device according to an embodiment of the present invention.

[FIG. 5] FIG. **5** is a schematic perspective view showing a structure of a sheet laminate **80** usable as a light guide element of a display device according to an embodiment of the present invention.

[FIG. 6] FIG. **6** is an enlarged schematic cross-sectional view of light guide portions of the sheet laminate **90.**

[FIG. 7] FIG. **7** is an enlarged schematic cross-sectional view of light guide portions of the sheet laminate **80.**

[FIG. 8] FIG. **8** is a cross-sectional view of a light guide element (sheet laminate **90)** in the case where a non-display region **30** has a small width.

[FIG. 9] FIG. **9** is a cross-sectional view of a light guide element (sheet laminate **90)** in the case where the non-display region **30** has a large width.

[FIG. 10] FIGS. **10(a)** and **(b)** are schematic views illustrating a method for producing the sheet laminate **90.**

[FIG. 11] FIG. **11** is a schematic cross-sectional view of a liquid crystal display device **200** according to an embodiment of the present invention.

[FIG. 12] FIG. **12** is an enlarged schematic cross-sectional view of a joint between liquid crystal display panels **10a** and **10b.**

[FIG. 13] FIG. **13** is a schematic perspective view of the liquid crystal display device **200** according to an embodiment of the present invention.

[FIG. 14] FIG. **14** is a schematic perspective view of a sheet laminate **40.**

[FIG. 15] FIGS. **15(a)** and **(b)** are schematic views illustrating a method for producing the sheet laminate **40.**

[FIG. 16] FIG. **16** is a schematic view illustrating the design of a light guide element.

[FIG. 17] FIG. **17** is a schematic cross-sectional view of another display device **200'** according to an embodiment of the present invention.

[FIG. 18] FIG. **18** is an enlarged schematic cross-sectional view of a joint between liquid crystal display panels **10a'** and **10b'.**

[FIG. 19] FIG. **19** is a schematic cross-sectional view of still another display device **300** according to an embodiment of the present invention.

[FIG. 20] FIG. **20** is a schematic view illustrating a method (method 1) for displaying an image in a compressed form.

[FIG. 21] FIG. **21** is a schematic view illustrating a method (method 2) for displaying an image in a compressed form.

[FIG. 22] FIG. **22** is a schematic perspective view of still another display device **400** according to an embodiment of the present invention.

[FIG. 23] FIG. **23** show enlarged cross-sectional views of a movable portion of the still another display device **400** according to an embodiment of the present invention; FIG. **23(a)** shows an open state, and FIG. **23(b)** shows a closed state.

[FIG. 24] FIG. **24** is a schematic perspective view of still another display device **500** according to an embodiment of the present invention.

[FIG. 25] FIG. **25** is a schematic perspective view of still another display device **600** according to an embodiment of the present invention.

[FIG. 26] FIG. **26** is a schematic perspective view of a liquid crystal display device **100B** including a plurality of liquid crystal display devices arranged in a matrix.

[FIG. 27] FIG. **27** is a schematic perspective view of another liquid crystal display device **100C** according to an embodiment of the present invention.

[FIG. 28] FIG. **28** is a schematic perspective view of still another display device **700** according to an embodiment of the present invention.

[FIG. 29] FIG. **29** is a schematic perspective view of still another display device **800** according to an embodiment of the present invention.

[FIG. 30] FIG. **30** is a schematic perspective view of still another display device **900** according to an embodiment of the present invention.

[FIG. 31] FIG. **31** is a schematic cross-sectional view of a liquid crystal display device **100D** according to an embodiment of the present invention.

[FIG. 32] FIG. **32** is a schematic perspective view of a tapered light guide element **20B.**

[FIG. 33] FIG. **33** is a schematic cross-sectional view of an end of the liquid crystal display device **100D.**

[FIG. 34] FIG. **34** is a schematic cross-sectional view of an end of a liquid crystal display device **100D'.**

[FIG. 35] FIGS. **35(a)** and **(b)** are respectively schematic cross-sectional views of light guide sheets **27B** and **27C** usable for a liquid crystal display device according to an embodiment of the present invention.

[FIG. 36] FIGS. **36(a)** and **(b)** are schematic views illustrating a method for producing the sheet laminate **80.**

[FIG. 37] FIGS. **37(a)** and **(b)** are schematic views illustrating another method for producing the sheet laminate **80.**

[FIG. 38] FIG. **38** is a schematic view illustrating still another method for producing the sheet laminate **80.**

[FIG. 39] FIG. **39** is a schematic cross-sectional view of still another liquid crystal display device according to an embodiment of the present invention.

[FIG. 40] FIG. **40** is a schematic cross-sectional view of a liquid crystal display device **100e** including a liquid crystal display panel **10e** having pixels arrayed at a uniform pitch.

[FIG. 41] FIG. **41** is a schematic cross-sectional view of a liquid crystal display device **100f** including a liquid crystal display panel **10f** in which the pitch of pixels in a peripheral display region is narrower than the pitch of pixels in another region.

## DESCRIPTION OF EMBODIMENTS

Hereinafter, display devices according to embodiments of the present invention will be described with reference to the drawings.

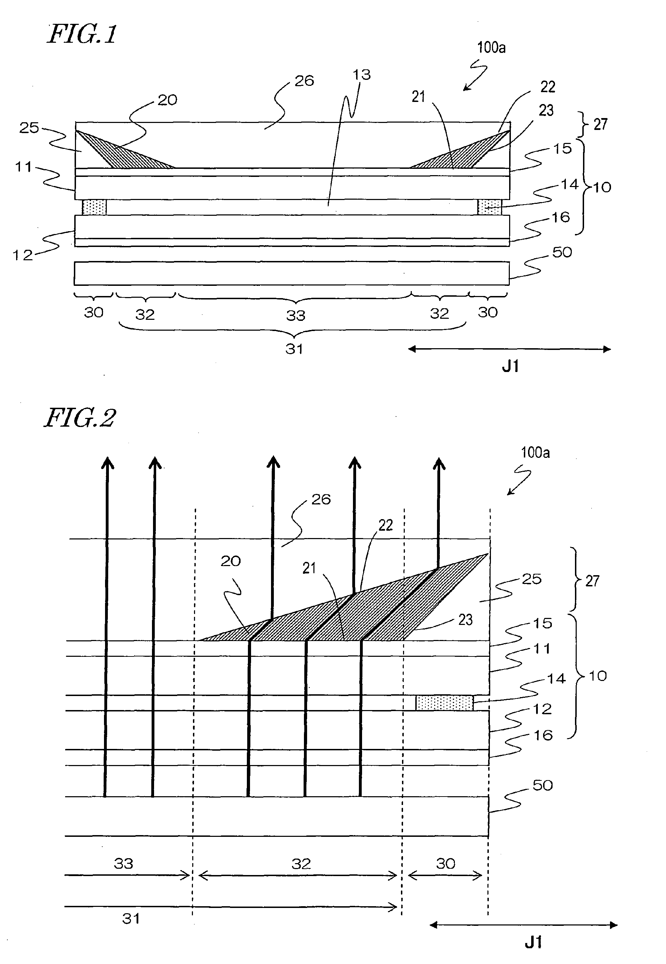

With reference to FIG. **1** through FIG. **3,** a structure and an operation of a display device according to an embodiment of the present invention will be described. Although a liquid crystal display device in which a liquid crystal display panel is used as a display panel will be described below, the display panel to be used for a display device according to the present invention is not limited thereto. As the display panel, for example, a display panel for PDP, an organic EL display panel, an electrophoretic display panel, or the like can be used.

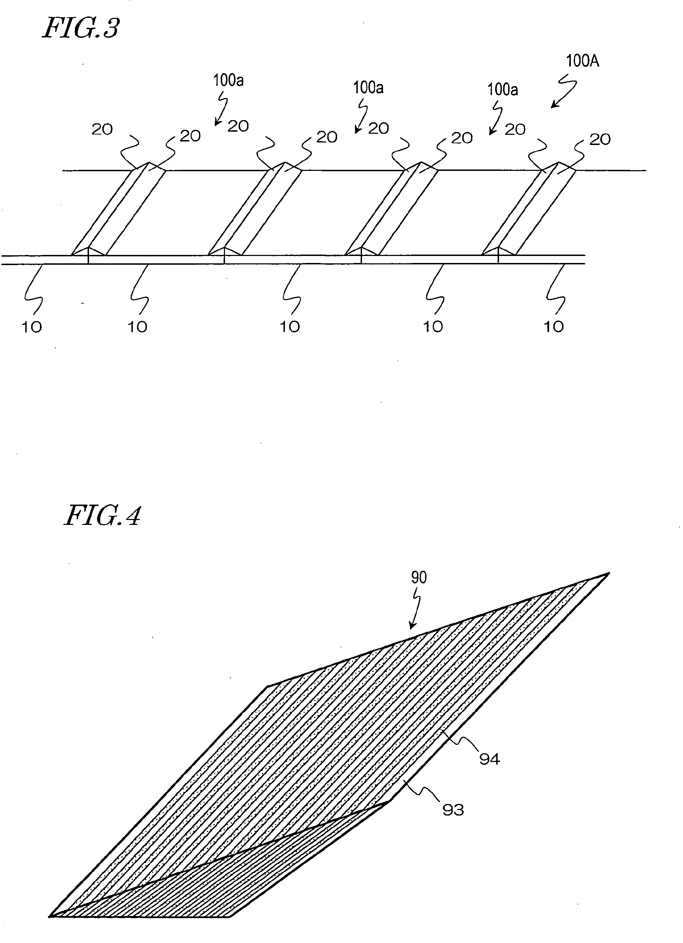

FIG. **1** is a schematic cross-sectional view of a liquid crystal display device **100a** according to an embodiment of the present invention. FIG. **2** is a schematic cross-sectional view of an end of the liquid crystal display device **100a.** FIG. **3** is a schematic perspective view of a liquid crystal display device **100A** including a plurality of liquid crystal display devices **100a.** The liquid crystal display device **100a** may be used independently, or a plurality of liquid crystal display device **100a** may be tiled as shown in FIG. **3** to form the large-sized liquid crystal display device **100A.** Tiling can be performed by any known method.

As shown in FIG. **1,** the liquid crystal display device **100a** includes a liquid crystal display panel **10,** and two light guide elements **20** provided on the viewer's side with respect to the liquid crystal display panel **10** and facing each other along a first axis **J1** (horizontal direction in FIG. **1).** The liquid crystal display device **100a** is of a transmission type and further includes a backlight device **50.** The liquid crystal display device **100a** provides display by modulating light going out from the backlight device **50** through the liquid crystal display panel **10.**

The liquid crystal display panel **10** may be any known liquid crystal display panel, and is, for example, a TFT liquid crystal display panel of a VA mode. The liquid crystal display panel **10** includes a TFT substrate **12** and a counter substrate **11,** with a liquid crystal layer **13** being provided between the TFT substrate **12** and the counter substrate **11.** The TFT substrate **12** includes TFTs and pixel electrodes, whereas the counter substrate **11** includes a color filter and a counter electrode. The liquid crystal layer **13** is retained between the TFT substrate **12** and the counter substrate **11** by means of a sealing portion **14.** On the viewer's side with respect to the counter substrate **11** (upper side in FIG. **1),** an optical film portion **15** is provided; and on the side opposite from the viewer's side with respect to the TFT substrate **12** (on the lower side in FIG. **1),** an optical film portion **16** is provided. The optical film portions **15** and **16** include a polarizer and a phase plate which is optionally provided.

The liquid crystal display panel **10** has a display region **31** in which a plurality of pixels are arrayed, and a frame region **30** lying outside the display region **31.** The frame region **30** includes a region in which the sealing portion **14,** terminals of various wiring lines, driving circuits and the like are provided. In general, the frame region **30** is provided with a light shielding film, and so does not contribute to display.

In the display region **31** of the liquid crystal display panel **10,** a plurality of pixels are arranged in a matrix having rows and columns. The row direction corresponds to the horizontal direction in a display plane of the liquid crystal display panel **10** (left-right direction in FIG. **1),** whereas the column direction corresponds to the vertical direction in the display plane (direction perpendicular to the sheet plane of FIG. **1).**

As the backlight device **50,** any known backlight device in a wide variety of devices is usable. For example, a direct-type backlight device having a plurality of cold cathode fluorescent tubes arranged in parallel is usable. Note that, as will be described later, it is preferable that the backlight device **50** allows the luminance distribution to be adjusted.

The light guide elements **20** provided on the viewer's side with respect to the liquid crystal display panel **10** each include an incident face **21,** an outgoing face **22,** and a plurality of light guide portions formed between the incident face **21** and the outgoing face **22.** The plurality of light guide portions include a transparent portion, and the transparent portion has a metal portion in at least a part of a side face thereof. The incident face **21** of each light guide element **20** is disposed so as to overlap a part **32** of a peripheral display region which adjoins the frame region **30** of the liquid crystal display panel **10** along the first axis **J1** and also so as to be parallel to a surface of the liquid crystal display panel **10** (referred to also as the "display plane"). Regarding the outgoing face **22** of each light guide element **20,** the distance thereof from the incident face **21** increases along the first axis **J1** from the part **32** of the peripheral display region toward the frame region **30.**

Herein, the first axis **J1** extends in the horizontal direction (parallel to the row direction of the liquid crystal display panel **10),** and FIG. **1** is a cross-sectional view taken along the first axis **J1.** In the liquid crystal display device **100a,** each light guide element **20** has a triangular cross-section. Each light guide element **20** has an overall shape of triangular prism whose cross-section perpendicular to a longitudinal direction thereof is triangular. This triangular prism is defined by the incident face **21,** the outgoing face **22,** and a side face **23.** In the liquid crystal display device **100a,** each light guide element **20** is disposed such that the longitudinal direction thereof is perpendicular to the horizontal direction of the liquid crystal display panel **10** (parallel to the column direction).

As described above, each light guide element **20** includes a plurality of light guide portions. The plurality of light guide portions include at least one transparent portion, and the transparent portion has a metal portion in at least a part of a side face thereof. Light incident on the incident face **21** of the light guide element **20** is propagated in the transparent portion and goes out from the outgoing face **22.** At this time, the light incident on the transparent portion is propagated in the transparent portion while being reflected by the metal portion provided in the side face of the transparent portion. In this manner, in the light guide element **20,** the transparent portion acts as a light guide portion. The metal portion of the light guide element **20** does not need to be provided in the entirety of the side face of the transparent portion, and merely needs to be provided such that the light incident on the transparent portion can be propagated by being reflected by the metal portion.

Now, with reference to FIG. **4,** a preferable structure of the light guide element **20** will be described.

As the light guide element **20,** for example, a laminate in which a plurality of transparent layers and a plurality of metal layers are stacked is usable. FIG. **4** is a perspective view schematically showing a triangular prism-shaped sheet laminate **90** usable as the light guide element **20**. The sheet laminate **90** includes transparent layers **93** and metal layers **94** stacked parallel to each other. In the sheet laminate **90,** the transparent layers **93** and metal layers **94** are stacked so as to extend parallel to each other in a direction perpendicular to a length direction thereof (propagation direction of light). The transparent layers **93** and metal layers **94** are stacked in a direction perpendicular to the side face **23** of the light guide element **20.** Light incident on the light guide element **20** through the incident face **21** is propagated in the transparent layers **93** parallel to the side face **23** and goes out toward the viewer's side through the outgoing face **22**. At this time, the light incident on the transparent layers **93** is propagated in the transparent layers **93** while being reflected by the adjoining metal layers **94**. On the incident face **21,** light is incident at various angles, but the sheet laminate **90** can allow all the light to be guided therein regardless of the incidence angle because the sheet laminate **90** utilizes the reflection by the metal layers **94**.

Also usable as the light guide element **20** is an element including a plurality of light guide portions which have generally cylindrical transparent portions having a side face partially covered with a metal portion. In this case, light incident on each transparent portion is propagated in the transparent portion while being reflected by the metal portion provided on the side face of the transparent portion. Namely, each individual transparent portion acts as a light guide portion. In this case, the light guide element **20** has a cross-section similar to that of the light guide elements **20** shown in FIG. **1** and FIG. **2**. Namely, the light guide element **20** is formed such that the transparent portions have a length direction parallel to the side face **23** of the light guide element **20**.

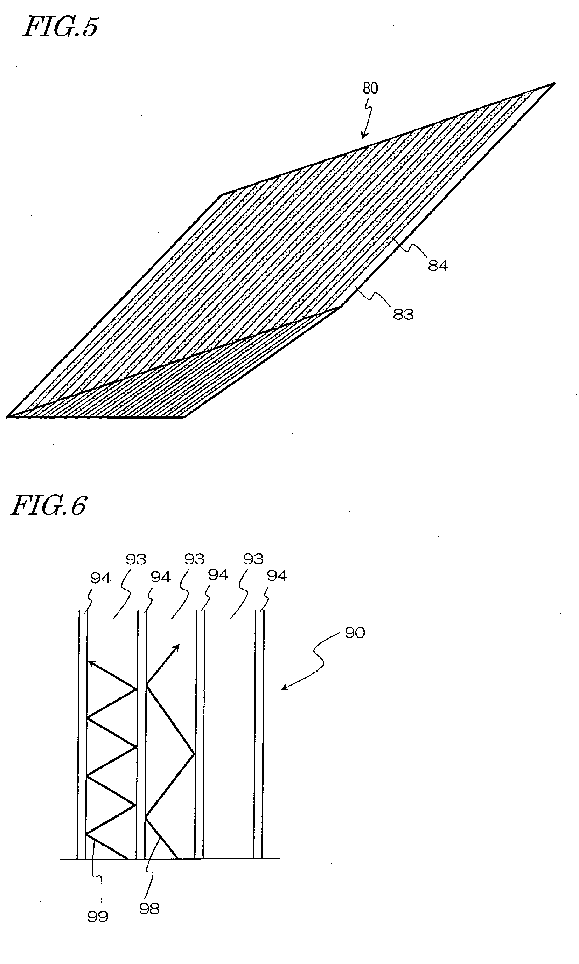

As the light guide element **20,** a sheet laminate **80** including a plurality of stacked light-transmissive layers is also usable. The sheet laminate **80** includes at least two types of stacked light-transmissive layers having different refractive indices. FIG. **5** is a perspective view of the sheet laminate **80** including two types of light-transmissive layers **83** and **84.** The sheet laminate **80** including such a plurality of stacked light-transmissive layers will be described in detail later.

Referring to FIG. **5,** in the sheet laminate **80,** the light-transmissive layers **83,** and the light-transmissive layers **84** having a lower refractive index than that of the light-transmissive layers **83,** are stacked parallel to each other. When the sheet laminate **80** is used as the light guide element **20,** light incident on the light guide element **20** through the incident face **21** is propagated in the light-transmissive layers **83** parallel to the side face **23** and goes out toward the viewer's side through the outgoing face **22.** Since the refractive index of the light-transmissive layers **83** is higher than that of the light-transmissive layers **84,** the light incident on the light-transmissive layers **83** is propagated in the light-transmissive layers **83** while being totally reflected by interfaces between the light-transmissive layers **83** and the light-transmissive layers **84**.

Total reflection is a phenomenon that when light is incident from a medium having a higher refractive index to a medium having a lower refractive index, the incident light is totally reflected without being transmitted though the interface between the two mediums. Total reflection occurs when the incidence angle is equal to or larger than a certain angle. This angle is referred to as the "critical angle". The level of the critical angle depends on the ratio of the refractive index of the light-transmissive layers **83** and the refractive index of the light-transmissive layers **84.** Of the light incident on the light-transmissive layers **83,** only the light incident at an angle larger than the critical angle can be propagated in the light-transmissive layers **83.** The reflectance of the light incident at an angle larger than the critical angle is 100%, whereas the light incident at an angle smaller than the critical angle is not reflected but is refracted and goes out from the light-transmissive layers **83.**

By contrast, the sheet laminate **90** guides the light utilizing the reflection by the metal layers **94,** and so can allow all the incident light to be propagated regardless of the incidence angle.

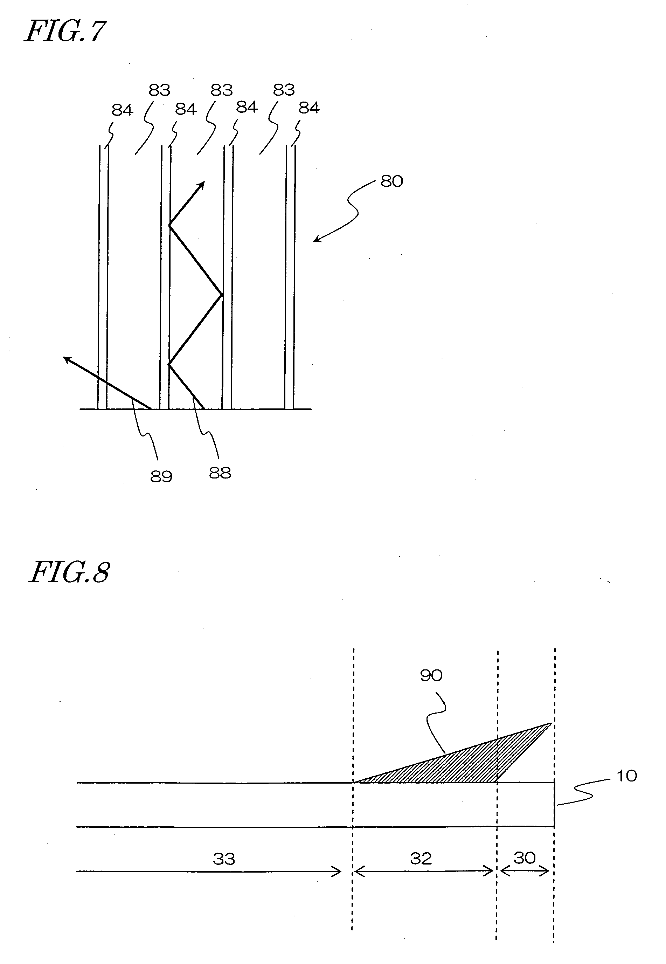

This will be described with reference to FIG. **6** and FIG. **7**. FIG. **6** is an enlarged schematic cross-sectional view showing light guide portions of the sheet laminate **90,** and FIG. **7** is an enlarged schematic cross-sectional view showing light guide portions of the sheet laminate **80**. FIG. **6** shows light beams **98** and **99** incident on the transparent layers **93** of the sheet laminate **90** at different incidence angles. Similarly, FIG. **7** shows light beams **88** and **89** incident on the sheet laminate **80**.

The sheet laminate **90** guides light utilizing reflection by metal and so can guide the light beams **98** and **99** incident at various angles (FIG. **6).** By contrast, the sheet laminate **80** guides the light beams **88** incident at an angle larger than the critical angle. However, the light beam **89** incident on the sheet laminate **80** at an angle smaller than the critical angle passes through the light-transmissive layers **84** and is incident on the adjoining light-transmissive layer **83** to become stray light; or in the case where the light-transmissive layers **84** have an absorbing layer formed therein, the light is absorbed by the absorbing layer (FIG. 7).

As described above, in the sheet laminate **80** utilizing total reflection, the range of incidence angles of light which can be propagated is narrower than in the sheet laminate **90** using the metal layer. The range of incidence angles of light which can be propagated depends on the level of the ratio of the refractive indices of the light-transmissive layers as described above. There are only limited materials which increase the ratio of the refractive indices of the light-transmissive layers, and so the light-transmissive layers **83** and **84** need to be formed of materials selected from such a limited range.

For example, when the light-transmissive layers **83** are formed of acrylic film having a relatively lower refractive index, the numerical aperture (NA) in the sense of optical fibers is decreased. Namely, the range of incidence angles of light which can be propagated is narrowed. Therefore, it is not preferable to use acrylic film for the light-transmissive layers **83**. Thus, for example, the light-transmissive layers **83** are formed of polyethylene terephthalate film (PET; refractive index: 1.65), and the light-transmissive layers **84** are formed of acrylic film (refractive index: 1.49). The transmittance of PET is lower than that of an acrylic resin, and so darkens display provided by PET.

By contrast, in the case of the sheet laminate **90**, the transparent layers **93** merely need to be transparent and there is no limitation on the refractive index. Therefore, the material used for the transparent layers **93** can be selected from a wide range. For the transparent layers **93**, acrylic film having a transmittance as high as that of glass (e.g., PMMA) is usable. Therefore, when the sheet laminate **90** is used as the light guide element **20**, the display can be made brighter than when the sheet laminate **80** is used. When the acrylic film is used for the transparent layers **93** of the sheet laminate **90**, "Acryplen" provided by Mitsubishi Rayon Co., Ltd. is usable, for example.

As is clear from FIG. **6** and FIG. **7**, the range of incidence angles of light which can be propagated is wider in the sheet laminate **90** than in the sheet laminate **80**, and so the viewing angle of the displayed image is advantageously wider when the sheet laminate **90** is used.

As the light guide element **20**, an optical fiber face plate is usable. As is well known, an optical fiber includes core and cladding outside the core. By making the refractive index of the core higher than that of the cladding, light can be propagated in the core utilizing total reflection. When an optical fiber face plate is used as the light guide element **20**, each individual optical fiber acts as a light guide portion. The optical fiber face plate will be described in detail later.

With an optical fiber face plate, the range of incidence angles of light which can be propagated is different depending on the level of the critical angle. Therefore, the core and the cladding each need to be formed of a material selected from a limited range. By contrast, a light guide element having a generally cylindrical transparent portion having a side face partially covered with a metal portion can be formed of a material selected from a wide range, like the sheet laminate **90**. In addition, such a light guide element utilizes reflection by metal and so allows all the light to be propagated regardless of the incidence angle. Accordingly, the viewing angle is made wider.

As described above, the light guide element **20** can be formed of a material selected from a wider range than the sheet laminate **80** including light-transmissive layers having different refractive indices or than a light guide element using an optical fiber face plate. Accordingly, a material having a high transmittance can be selected regardless of the refractive index, which realizes bright display. Since the material of the transparent portion can be selected from a wide range, a low-cost material can be used for the transparent portion. For the transparent portion, a low-cost material such as, for example, an acrylic resin or the like can be used instead of a material having a high refractive index such as generally high-cost glass, PET or the like. As a result, the light guide element **20** can be produced at low cost.

The liquid crystal display device **100a** includes the light guide elements **20** each disposed so as to overlap the part **32** of the peripheral display region which adjoins the frame region **30** and also overlap the frame region **30**, and does not include any light guide element in a majority of the display region **31** excluding the part **32** of the peripheral display region. Therefore, unlike the conventional display devices described in Patent Documents 1 through 3 mentioned above, the liquid crystal display device **100a** does not need a light guide element of a large area size, and so is advantageously low-cost.

The light guide elements **20** utilize reflection by metal and so can allow light to be propagated regardless of the incidence angle. Owing to this, the light guide elements **20** advantageously provide a wide viewing angle.

Now, with reference to FIG. **2**, a reason why the frame region **30** of the liquid crystal display panel **10** is obscure in the liquid crystal display device **100a** will be described.

The light incident on each light guide element **20** through the incident face **21** is propagated in the transparent portion parallel to the side face **23** and goes out toward the viewer's side through the outgoing face **22**. As described above, the incident face **21** overlaps the part **32** of the peripheral display region of the liquid crystal display panel **10**. Accordingly, owing to the light going out from the outgoing face **22**, an image formed on the part **32** of the peripheral display region is displayed on the viewer's side with respect to the light guide element **20**. In the liquid crystal display device **100a**, the outgoing face **22** of the light guide element **20** extends to a position overlapping the frame region **30**. The outgoing face **22** is not parallel to the incident face **21**, and is formed such that the distance thereof from the incident face **21** increases toward the frame region **30**. Accordingly, the display light (image information) incident on the incident face **21** goes out through the outgoing face as being enlarged. Owing to this, the image is displayed on the viewer's side with respect to the frame region **30** of the liquid crystal display panel **10**. This obscures the frame region.

In the liquid crystal display device **100a**, the outgoing face **22** of the light guide element **20** may be extended to a position matching an end of the liquid crystal display panel **10**. This is preferable because the outgoing face **22** covers the entirety of the frame region 30 and so the viewer does not visually recognize any part of the frame region **30.**

In the case where the liquid crystal display device **100a** is used independently, the frame region is obscured or an area size of the frame region visually recognizable is smaller than the frame region **30** of the liquid crystal display panel **10.** In this case, the structure of the liquid crystal display device **100a** is not limited to having two light guide elements **20** respectively for two portions of the frame region facing each other in the horizontal direction as described above. Alternatively, light guide elements **20** may be provided for another two portions of the frame region facing each other in the vertical direction, so that the frame region portions on all the four sides of the liquid crystal display device **100a** are obscure or visually unrecognizable. Depending on the purpose of use of the liquid crystal display device **100a,** the light guide element **20** may be provided on only one side, or the light guide elements **20** may be provided on any two or three sides. In these cases, the frame region is obscured along each side on which the light guide element **20** is provided on the viewer's side.

In the case where a plurality of liquid crystal display devices **100a** are tiled, a display device having joints thereof obscured can be obtained by providing the light guide elements **20** on the sides along which the liquid crystal display devices **100a** adjoin each other. For example, a large-sized liquid crystal display device **100A** shown in FIG. **3** can be obtained by arranging a plurality of liquid crystal display devices **100a** in a line. In this large-sized liquid crystal display device **100A,** the light guide elements **20** are provided on the sides along which the plurality of liquid crystal display devices **100a** adjoin each other. Owing to this, the large-sized liquid crystal display device **100A** can realize display having joints thereof obscured.

As the material of the metal layers **94** in the sheet laminate **90,** a metal having a high reflectance such as aluminum (Al), silver (Ag) or the like is usable. It should be noted that the reflectance of aluminum is about 90% and the reflectance of silver is about 98%, for example, and so each time light is reflected by the metal layers **94,** a part of the light is absorbed. Instead of the metal layers **94,** a reflective film which does not absorb light on principle such as a dielectric multi-layer film or the like is usable. However, the dielectric multi-layer film is not preferable due to high production cost thereof.

In the sheet laminate **90** including the metal layers, as the length of a light guide path (length of the light guide portion in the propagation direction of light) is greater, the number of times of reflection is increased and so the amount of light absorbed by the metal layers **94** is increased. By contrast, in the sheet laminate **80** utilizing total reflection, the reflectance by the interfaces between the light-transmissive layers **83** and the light-transmissive layers **84** is 100%. Therefore, even where the light guide path is made longer, the light is not absorbed by the interfaces.

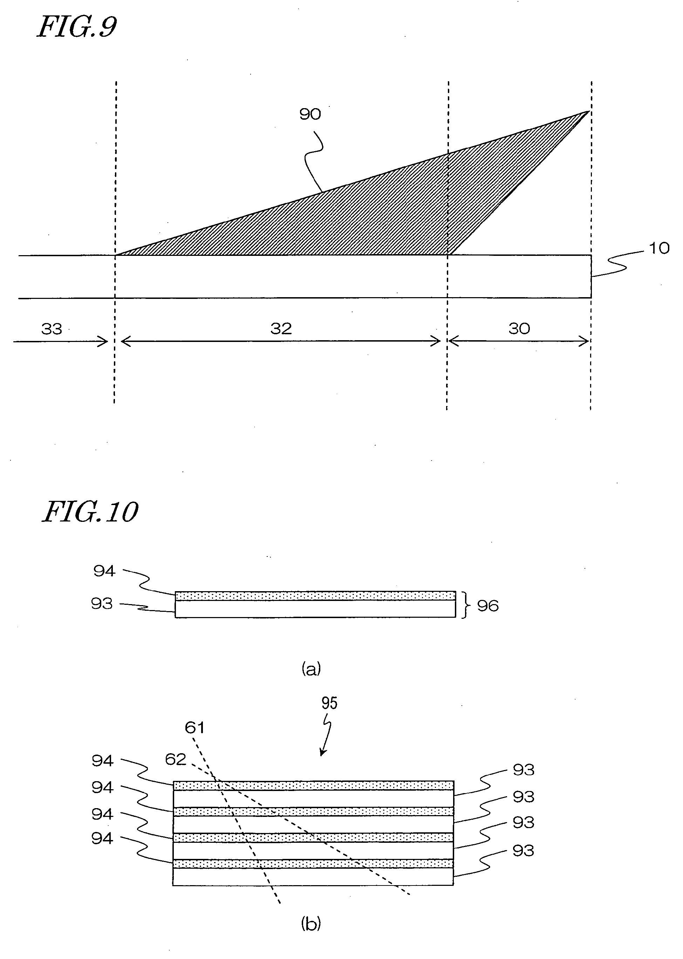

With reference to FIG. **8** and FIG. **9,** why in the sheet laminate **90** including the metal layers, the degree of reduction in the transmittance of light is different depending on the length of the light guide path will be described.

FIG. **8** shows a cross-sectional view of the light guide element **20** in the case where the non-display region (frame region) **30** has a small width. FIG. **9** shows a cross-sectional view of the light guide element **20** in the case where the non-display region (frame region) **30** has a large width. As shown in FIG. **8,** in the case where the width of the non-display region **30** is relatively small, the light guide path is relatively short. As shown in FIG. **9,** in the case where the width of the non-display region **30** is relatively large, the light guide path is relatively long. As can be seen, the length of the light guide path depends on the width of the non-display region **30.** In the case where the width of the non-display region **30** is relatively small (e.g., 5 mm or less) as shown in FIG. **8,** the light guide path is short and the number of times of reflection is small. Therefore, the transmittance of the sheet laminate **90** including the metal layers is higher than that of the sheet laminate **80** utilizing total reflection. By contrast, in the case where the width of the non-display region **30** is relatively large (e.g., 5 mm or greater) as shown in FIG. **9,** the light guide path is long and the number of times of reflection is large. Therefore, the transmittance of the sheet laminate **80** utilizing total reflection is higher. The transmittance is changed in accordance with the length of the light guide path as well as the material used, the type of adhesive, tacky agent or the like; and so which structure is advantageous is changed accordingly. The sheet laminate **90** including the metal layers has the transmittance thereof changed in accordance with the length of the light guide path, but allows light incident at an angle in a wider range to be propagated. Therefore, the material for the transparent layers **93** can be selected from a wider range, and so a material having a high transmittance can be selected. Accordingly, the sheet laminate **90** including the metal layers is more advantageous than the sheet laminate **80** utilizing total reflection.

The liquid crystal display device **100a** may include a light-transmissive cover (cover **26**) for covering the display region **31** of the liquid crystal display panel **10** and the outgoing faces **22** of the two light guide elements **20** (shown in FIG. **1** and FIG. **2).** In this case, the cover **26** and the light guide elements **20** are fixed to the surface of the liquid crystal display panel **10** by a transparent adhesive layer not shown. The light guide elements **20** may each be further fixed by a resin layer **25** formed between the side face **23** and the surface of the liquid crystal display panel **10.** The resin layers **25** may be omitted, but the light guide elements **20** can be fixed more stably with the resin layers **25.** The cover **26** is fixed to the outgoing face **22** of each light guide element **20** by an adhesive layer. The adhesive layer between the light guide element **20** and the liquid crystal display panel **10** is not absolutely necessary. The light guide element **20** and the liquid crystal display panel **10** may be fixed to each other by an air layer provided therebetween.

The light guide elements **20,** the cover **26** and the resin layers **25** provided on the surface, on the viewer's side,

of the liquid crystal display panel **10** are collectively referred to as a "light guide sheet **27**" occasionally. By providing the cover **26** and the resin layers **25** in the form of a sheet having a flat surface, the light guide elements **20** and the display plane of the liquid crystal display panel **10** can be protected. Since this flattens a surface of the liquid crystal display device **100a**, the liquid crystal display device **100a** appears more natural. There is another advantage that any stain on the surface can be wiped out more easily. The cover **26** is, for example, a resin plate (e.g., an acrylic resin plate) pre-molded so as to be aligned to the shape of the light guide elements **20** and the display plane of the liquid crystal display panel **10.** By providing the cover **26,** the display quality of the liquid crystal display device **100a** can be improved.

As the cover **26** and the light guide sheet **27,** those similar to the cover **26** and the light guide sheet **27** used for a liquid crystal display device **100D,** using an optical fiber face plate as the light guide element 20 described later in detail, are preferably usable.

In a liquid crystal display device according to the present invention, a light guide element which includes a transparent portion having a metal portion on a side face thereof is used. The material of the transparent portion merely needs to be transparent, and there is no limitation on the refractive index. This provides an advantage that the material can be selected from a wider range. Accordingly, a material having a high transmittance can be used regardless of the refractive index. This suppresses the non-display region from becoming dark. In addition, the light guide element utilizes reflection by metal, and so all the light can be guided regardless of the incidence angle thereof. This widens the viewing angle. Since the material of the transparent portion can be selected from a wide range, a low-cost material can be selected for the transparent portion, which reduces the cost. The use of such a light guide element can obscure the frame region of the display panel or the joints between a plurality of tiled liquid crystal display panels.

Now, with reference to FIG. **10,** a method for producing the light guide element **20** utilizing reflection by metal will be described. Here, a method for producing the sheet laminate **90** having a triangular prism shape shown in FIG. **4** will be described. The sheet laminate **90** can be easily produced by the following method.

As shown in FIG. **10(a),** on one surface of the transparent layer **93** formed of a light-transmissive material such as an acrylic resin or glass, the metal layer **94** formed of a material having a high light reflectance such as aluminum (A1), silver (Ag) or the like is formed by vapor deposition or sputtering. Thus, a laminate film **96** is obtained.

Preferably, the plurality of metal layers **94** included in the sheet laminate **90** include a metal layer having a thickness of 100 nm or greater and 5 $\mu$m or less. When the thickness of the metal layer **94** is less than 100 nm, a sufficient level of light reflecting characteristic may not be obtained occasionally. When the thickness of the metal layer is greater than 5 $\mu$m, the ratio of the transparent layers **93** with respect to the incident face of the sheet laminate **90** is small enough to reduce the light transmittance. This is non-preferable because the luminance of display is reduced. More preferably, the plurality of metal layers include a metal layer having a thickness of 1 $\mu$m or less because as the thickness of the layers formed by vapor deposition or sputtering is larger (e.g., greater than 1 $\mu$m), the production time and cost are increased. It is preferable that the thickness of all the metal layers in the sheet laminate **90** is in the above-mentioned range, but the thickness of a part of the metal layers may be outside the above-mentioned range.

Preferably, the metal layers **94** do not cause scattering or the like at a surface thereof and that the reflection by the surface is close to mirror reflection.

Next, a plurality of laminate films **96,** each including the transparent layer **93** and the metal layer **94** formed on the surface of the transparent layer **93,** are stacked with tacky or adhesive layers being interposed therebetween, and then are cured so that the layers are not delaminated. Thus, a laminate **95** is obtained (FIG. **10(b)).** As the tacky or adhesive material, for example, a resin material such as a thermosetting resin, a thermoplastic resin or the like is usable, for example. It is preferable that the thickness of the tacky or adhesive layers is as small as possible in the range in which the layers have a high light transmissivity, low light scattering characteristics and a sufficient level of strength after being cured. In the case where the transparent layers **93** are tacky or adhesive, there is no particular need to separately provide such tacky or adhesive layers.

Next, the laminate **95** obtained as described above is cut obliquely with respect to the direction of the surfaces of the transparent layers **93** and the metal layers **94** as represented by dashed lines **61** and **62** in FIG. **10(b).** The cut surfaces are polished when necessary to improve the external appearance. Thus, the triangular prism-shaped sheet laminate **90** shown in FIG. **4** is obtained.

The direction of cutting is a parameter which is determined based on the width of the non-display region (frame region) **30** of the liquid crystal display panel **10** and the area size of the region **32** in which the sheet laminate **90** is to be located (part **32** of the peripheral display region). The sheet laminate **90** used as the light guide element **20** of the liquid crystal display device **100a** is produced with the following angles: the angle made by the dashed line **61** and the direction of the surfaces of the transparent layers **93** and the metal layers **94** is 65 degrees; and the angle made by the dashed line **62** and the direction of the surfaces of the transparent layers **93** and the metal layers **94** is 30 degrees.

In the case where the transparent layers **93** can be flexibly curved like film substrates formed of a resin material, the plurality of laminate films **96,** each including the transparent layer **93** and the metal layer **94** formed on the surface of the transparent layer **93,** may be fused by a roll-to-roll process. In this manner, the sheet laminate **90** can be produced more easily. As the roll-to-roll process for fusing the laminate films **96,** one similar to a roll-to-roll process described later as a method for producing the sheet laminate **80** is usable.

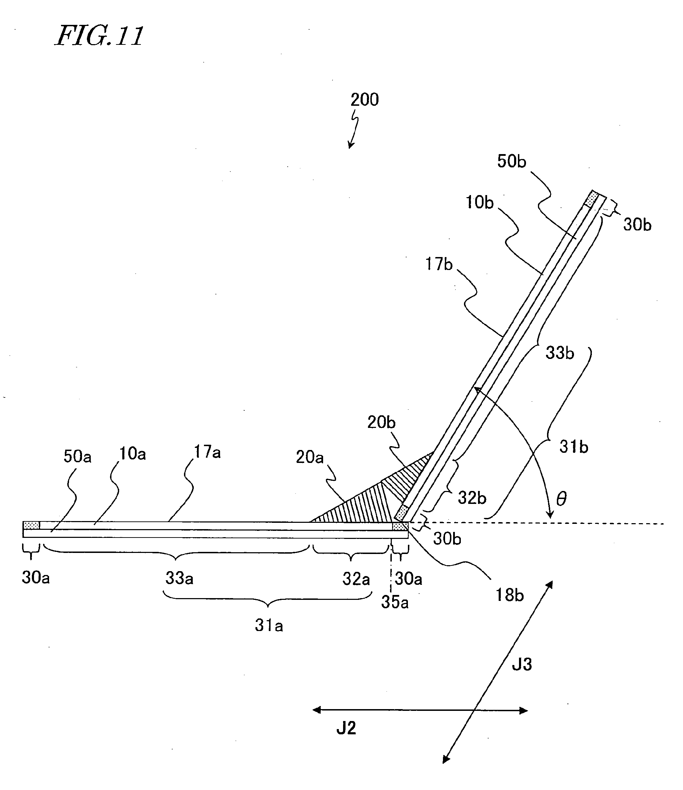

Now, with reference to FIG. **11** through FIG. **41,** various specific examples of display device according to embodiments of the present invention will be described.

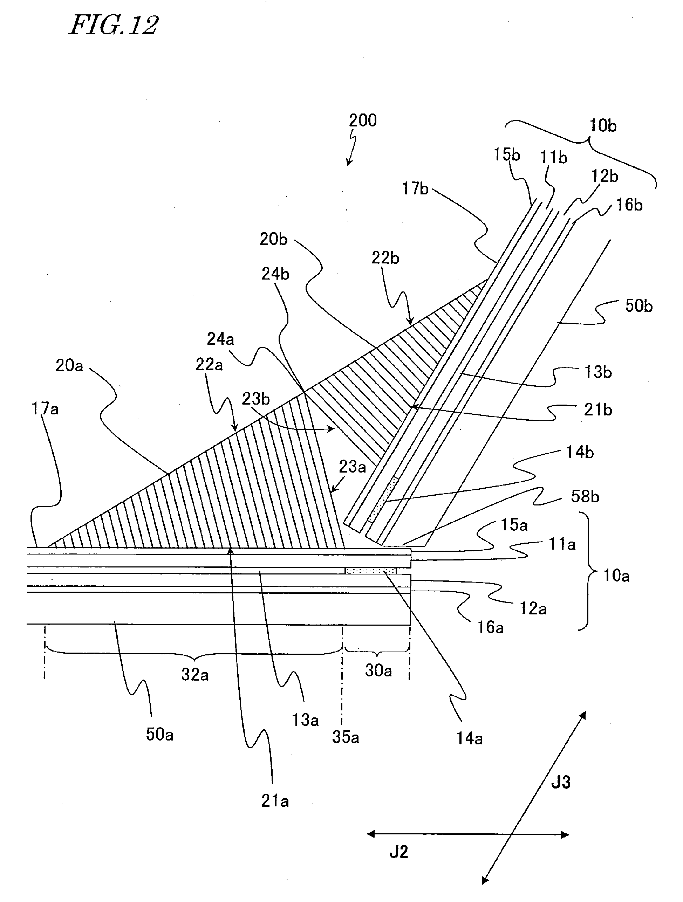

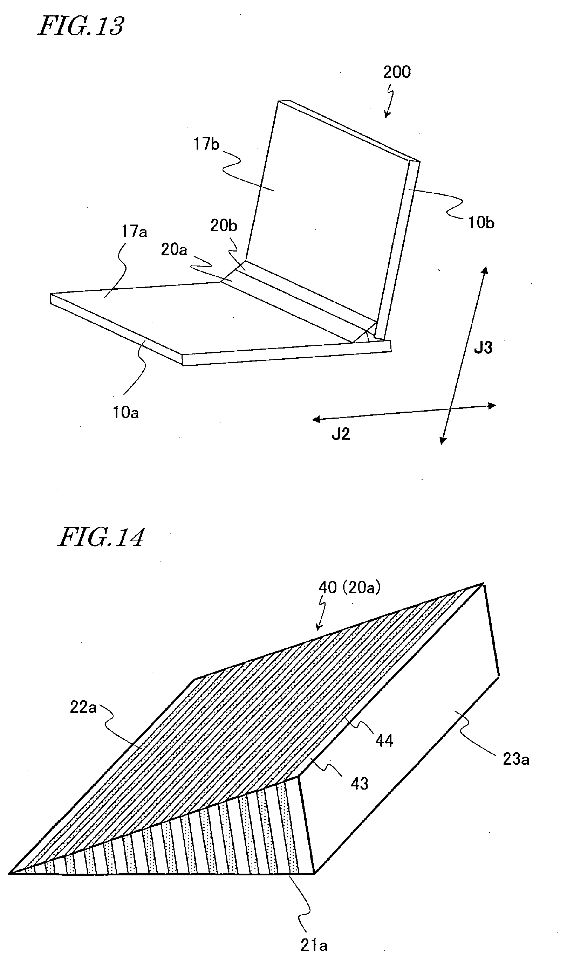

FIG. **11** is a schematic cross-sectional view of a liquid crystal display device **200** according to an embodiment of the present invention. The liquid crystal display device **200** shown in FIG. **11** includes two liquid crystal display panels **1l0a** and **10b** adjoining each other and two light guide elements **20a** and **20b**. The liquid crystal display device **200** includes the two liquid crystal display panels **10a** and **10b** tiled at a prescribed angle (θ described later). The tiling can be performed by any known method. FIG. **12** is an enlarged view of a joint between the liquid crystal display panels **10a** and **10b** of the liquid crystal display device **200**. The joint of the liquid crystal display device **200** will be described later. FIG. **13** is a schematic perspective view of the liquid crystal display device **200**. FIG. **11** is a cross-sectional view of the liquid crystal display device **200** shown in FIG. **13** taken long a plane perpendicular to viewer-side surfaces **17a** and **17b** of the liquid crystal display panels **10a** and **10b**.

As shown in FIG. **11** and FIG. **12,** a light guide element **20a** is provided on the viewer-side surface **17a** of the liquid crystal display panel **10a**. The liquid crystal display device **200** is of a transmission type, and includes a backlight device **50a** provided on the side opposite from the viewer's side with respect to the liquid crystal display panel **10a** (provided on the lower side in FIG. **11** and FIG. **12).** The liquid crystal display device **200** provides display by modulating light going out from the backlight device **50a** through the liquid crystal display panel **10a**. Similarly to the liquid crystal display panel **10a,** a light guide element **20b** is provided on the viewer-side surface **17b** of the liquid crystal display panel **10b,** and a backlight device **50b** is provided on the side opposite from the viewer's side.

The liquid crystal display device **200** includes the two liquid crystal display panels **10a** and **10b,** but may include more display panels, needless to say. Examples of display devices having three or more display panels will be described later.

The liquid crystal display panel **10a** may be any known liquid crystal display panel, and is, for example, a TFT liquid crystal display panel of a VA mode. As shown in FIG. **12,** the liquid crystal display panel **10a** includes a TFT substrate **12a** and a counter substrate **11a,** with a liquid crystal layer **13a** being provided between the TFT substrate **12a** and the counter substrate **11a**. The TFT substrate **12a** includes TFTs and pixel electrodes, whereas the counter substrate **11a** includes a color filter and a counter electrode. The liquid crystal layer **13a** is retained between the counter substrate **11a** and the TFT substrate **12a** by means of a sealing portion **14a**. On the viewer's side with respect to the counter substrate **11a** (upper side in FIG. **12),** an optical film portion **15a** is provided; and on the side opposite from the viewer's side with respect to the TFT substrate **12a** (on the lower side in FIG. **12),** an optical film portion **16a** is provided. The optical film portions **15a** and **16a** include a polarizer and a phase plate which is optionally provided. The liquid crystal display panel **10b** includes a TFT substrate **12b,** a counter substrate **11b,** a liquid crystal layer **13b,** a sealing portion **14b,** optical film portions **15b** and **16b** and the like, like the liquid crystal display panel **10a**.

The liquid crystal display panels **10a** and **10b** respectively have display regions **31a** and **31b** in which a plurality of pixels are arrayed, and frame regions **30a** and **30b** lying outside the display regions **31a** and **31b**. The frame regions **30a** and **30b** include regions in which the sealing portions **14a** and **14b,** terminals of various wiring lines, driving circuits and the like are provided. In general, the frame regions **30a** and **30b** are provided with light shielding films, and so do not contribute to display.

In the display region **31a** of the liquid crystal display panel **10a,** a plurality of pixels (not shown) are arranged in a matrix having rows and columns. The row direction corresponds to the horizontal direction in the display plane of the liquid crystal display panel **10a** (direction perpendicular to the sheet plane of FIG. **11),** whereas the column direction corresponds to the vertical direction in the display plane (left-right direction in FIG. **11).** In the display region **31b** of the liquid crystal display panel **10b,** a plurality of pixels are arranged in a matrix having rows and columns, like in the liquid crystal display panel **10a**.

The backlight devices **50a** and **50b** are each, for example, a direct-type backlight device having a plurality of fluorescent tubes arranged in parallel. Note that, as will be described later, it is preferable that the backlight devices **50a** and **50b** allow the luminance distribution to be adjusted.

As shown in FIG. 11, the liquid crystal display panel **10a** and the liquid crystal display panel **10b** are disposed such that the angle made by the viewer-side surface **17a** of the liquid crystal display panel **10a** and the viewer-side surface **17b** of the liquid crystal display panel **10b** is a prescribed angle θ (0° < θ < 180°). As shown in FIG. 11, the angle θ represents an angle made by the viewer-side surface **17b** of the liquid crystal display panel 10b and a plane which is an extension of the viewer-side surface 17a of the liquid crystal display panel **10a** toward the liquid crystal display panel **10b.**

The angle θ may be set to any of various angles depending on the product form. In the liquid crystal display device 200 shown in FIG. 11, θ = 60°.

The liquid crystal display panels **10a** and **10b** are disposed such that the frame region of one of the liquid crystal display panels overlaps a side face of the other liquid crystal display panel. In the liquid crystal display device **200,** the frame region **30a** of the liquid crystal display panel **10a** overlaps a side face **18b** of the liquid crystal display panel **10b.**

As shown in FIG. **12,** the light guide element **20a** disposed on the viewer's side with respect to the liquid crystal display panel **10a** includes an incident face **21a,** an outgoing face **22a,** and a plurality of light guide portions formed between the incident face **21a** and the outgoing face **22a.** The incident face **21a** of the light guide element **20a** overlaps a peripheral display region **32a,** which is a region of the display region **31a** of the liquid crystal display panel **10a** that adjoins the frame region **30a** along a second axis **(J2).** The incident face **21a** overlaps a peripheral display region adjoining a portion of the frame region **30a** that is on the side adjoining the liquid crystal display panel **10b** along the second axis **J2.** The light guide element **20a** is also disposed such that the incident face **21a** is parallel to the viewer-side surface **17a** of the liquid crystal display panel **10a.** Herein, the second axis **J2** is an axis extending parallel to the column direction of the liquid crystal display panel **10a** (vertical direction in the display plane of the liquid crystal display panel **10a).** The distance between the incident face **21a** and the outgoing face **22a** increases along the second axis **J2** from the peripheral display region **32a** toward the frame region **30a** (from left to right in FIG. **12).** In the liquid crystal display device 200, the incident face **21a** extends to a boundary **35a** between the peripheral display region **32a** and the frame region **30a.**

Similarly to the light guide element **20a,** the light guide element **20b** includes an incident face **21b,** an outgoing face **22b,** and a plurality of light guide portions formed between the incident face **21b** and the outgoing face **22b.** The incident face **21b** is disposed so as to overlap a peripheral display region **32b,** which is a region of the display region **31b** of the liquid crystal display panel **10b** that adjoins the frame region **30b** along a third axis **J3** (the frame region **30b,** the display region **31b,** and the peripheral display region **32b** are shown in FIG. **11).** The distance between the incident face **21b** and the outgoing face **22b** increases along the third axis **J3** from the peripheral display region **32b** toward the frame region **30b.** Herein, the third axis J3 is an axis extending parallel to the column direction of the liquid crystal display panel **10b** (vertical direction in the display plane of the liquid crystal display panel **10b).**

In the liquid crystal display device 200, the light guide element **20a** has a triangular cross-section. The light guide element **20a** has an overall shape of triangular prism whose cross-section perpendicular to a longitudinal direction thereof is triangular. This triangular prism is defined by the incident face **21a,** the outgoing face **22a,** and a side face **23a.** Similarly, the light guide element **20b** has an overall shape of triangular prism whose cross-section perpendicular to a longitudinal direction thereof is triangular. This triangular prism is defined by the incident face **21b,** the outgoing face **22b,** and a side face **23b.** In the liquid crystal display device **200,** the light guide elements **20a** and **20b** are disposed such that the longitudinal directions thereof are parallel to the horizontal direction in the display planes of the liquid crystal display panels **10a** and **10b.**

Since the light guide element **20a** has a triangular prism shape, the outgoing face **22a** lies on the viewer's side with respect to the viewer-side surface **17a** of the liquid crystal display panel **10a.** Similarly, since the light guide element **20b** has a triangular prism shape, the outgoing face **22b** lies on the viewer's side with respect to the viewer-side surface **17b** of the liquid crystal display panel **10b.** Therefore, the outgoing faces **22a** and **22b** exist on the viewer's side with respect to the peripheral display region **32a,** the frame region **30a,** the frame region **30b** and the peripheral display region **32b.**

Like the light guide elements **20** of the liquid crystal display device **100a** described above, the light guide elements **20a** and **20b** of the liquid crystal display device **200** each include a plurality of light guide portions, which include a transparent portion having a metal portion in at least a part of a side face thereof. Usable as such a light guide element is, for example, a light guide element which is a sheet laminate in which a plurality of transparent layers and a plurality of metal layers are stacked, or a light guide element including a generally cylindrical transparent portion having a side face covered with a metal portion. Herein, a case where a sheet laminate in which a plurality of transparent layers and a plurality of metal layers are stacked is used as each of the light guide elements **20a** and **20b** will be described. As shown in FIG. **12,** the light guide element **20a** of the liquid crystal display device **200** includes transparent layers and metal layers stacked parallel to the side face **23a** thereof. Similarly, the light guide element **20b** includes transparent layers and metal layers stacked parallel to the side face **23b** thereof.

Light incident on the light guide element **20a** through the incident face **21a** is propagated in the transparent portions and goes out toward the viewer's side through the outgoing face **22a.** As described above, the incident face **21a** overlaps the peripheral display region **32a** of the liquid crystal display panel **10a.** Therefore, light which goes out from the pixels in the peripheral display region **32a** enters the light guide element **20a** through the incident face **21a,** is propagated in each individual light guide path parallel to the side face **23a,** and goes out from the outgoing face **22a.** Accordingly, an image formed in the partial peripheral display region **32a** is displayed on the viewer's side with respect to the light guide element **20a.** In the liquid crystal display device **200,** the light guide element **20b** is also a sheet laminate similar to the light guide element **20a.** Light which goes out from the pixels in the peripheral display region **32b** enters the light guide element **20b** through the incident face **21b,** is propagated in each individual light guide path parallel to the side face **23b,** and goes out from the outgoing face **22b.** Accordingly, an image formed in the partial peripheral display region **32b** of the liquid crystal display panel **10b** is displayed on the viewer's side with respect to the light guide element **20b.**

The outgoing faces **22a** and **22b** exist on the viewer's side with respect to the peripheral display region **32a,** the frame region **30a,** the frame region **30b** and the peripheral display region **32b.** Therefore, as a result of the images formed in the peripheral display regions **32a** and **32b** being displayed on the viewer's side with respect to the light guide elements **20a** and **20b,** the frame regions **30a** and **30b** are obscured. Owing to this, in the liquid crystal display device **200,** the joint between the liquid crystal display panel **10a** and the liquid crystal display panel **10b** is obscure.

As shown in FIG. **12,** in the liquid crystal display device **200,** an end **24a** of the outgoing face **22a** of the light guide element **20a** that is on the liquid crystal display panel **10b** side (corresponding to a line of intersection between the outgoing face **22a** and the side face **23a)** abuts on an end **24b** of the outgoing face **22b** of the light guide element **20b** that is on the liquid crystal display panel **10a** side (corresponding to a line of intersection between the outgoing face **22b** and the side face **23b).** Therefore, in the liquid crystal display device **200,** the outgoing face **22a** and the outgoing face **22b** are visually recognized as being continuous to each other. This realizes display with a further obscured joint. Furthermore, in the liquid crystal display device **200,** the outgoing face **22a** of the light guide element **20a** and the outgoing face **22b** of the light guide element **20b** are parallel to each other. Therefore, the outgoing face **22a** and the outgoing face **22b** are coplanar, so that the outgoing faces **22a** and **22b** appear to form one plane for the viewer. This realizes display with a still further obscured joint. In other words, the liquid crystal display device **200** can display a continuous image with no joints, because of the outgoing face **22a** of the light guide element **20a** and the outgoing face **22b** of the light guide element **20b** being coplanar. Examples of design values of the light guide elements will be described later.

The sheet laminate used as each of the light guide elements **20a** and **20b** can be produced by cutting a plate-like laminate into a triangular prism having the incident face and the outgoing face, like the light guide elements **20** of the liquid crystal display device **100a** described above.

FIG. **14** shows a perspective view of a triangular-prism-shaped sheet laminate **40** usable as the light guide element **20a** of the liquid crystal display device **200.** The sheet laminate **40** is formed of a laminate of transparent layers **43** and metal layers **44.** FIG. **14** also shows the incident face **21a,** the outgoing face **22a,** and the side face **23a** in the case where the light guide element **20a** is formed of the sheet laminate. As shown in FIG. **14,** when the sheet laminate is used as the light guide element **20a,** the side face **23a** is parallel to the layer stacking direction of the sheet. When the sheet laminate **40** is used as each of the light guide elements **20a** and **20b,** the transparent layers **43** and the metal layers **44** are parallel to the side face **23a** of each of the light guide element **20a** and the light guide element **20b** in FIG. **12.**

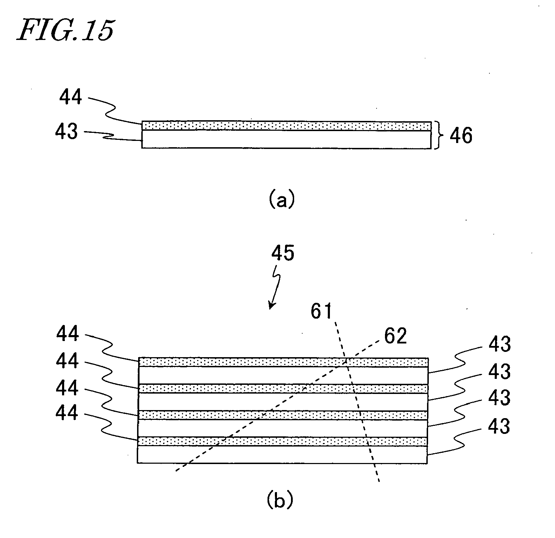

With reference to FIG. **15,** a method for producing the sheet laminate **40** will be described.

Like the sheet laminate **90** usable as the light guide element **20** of the liquid crystal display device **100a,** as shown in FIG. **15(a),** on one surface of the transparent layer **43** formed of a light-transmissive material such as an acrylic resin or glass, the metal layer **94** is formed. The resultant substance is dried and cured. Thus, a laminate film **46** is obtained. Next, a plurality of laminate films **46** are stacked with tacky or adhesive layers being interposed therebetween, and then are cured so that the layers are not delaminated. Thus, a laminate **45** (FIG. **15(b))** similar to the laminate **95** (FIG. **10(b))** is obtained.

Next, the laminate **45** is cut along the cutting planes (represented by dashed lines **61** and **62).** The laminate **45** is cut obliquely with respect to the adhering surface of the transparent layers **93** and the metal layers **94** as represented by dashed lines **61** and **62.** The cut surfaces are polished when necessary to improve the external appearance. Thus, the triangular prism-shaped sheet laminate **40** shown in FIG. **14** is obtained.

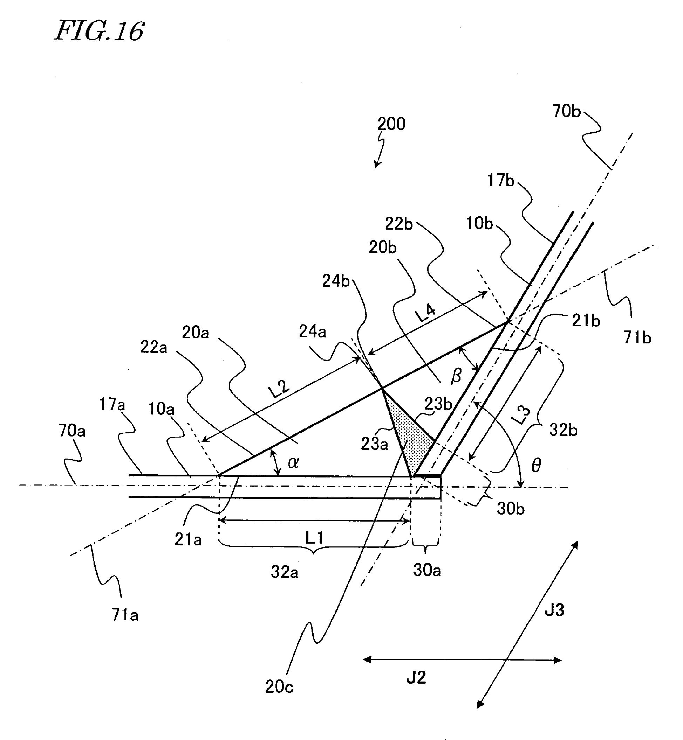

Now, with reference to FIG. **16,** the angle ($\theta$) made by the liquid crystal display panel **10a** and the liquid crystal display panel **10b,** and examples of design values of the light guide elements **20a** and **20b** of the liquid crystal display device **200** will be described.

FIG. **16** is a cross-sectional view schematically showing the relationship between the liquid crystal display panels **10a** and **10b** and the light guide elements **20a** and **20b.** The direction of a plane parallel to the viewer-side surface **17a** of the liquid crystal display panel **10a** is represented by a one-dot chain line **70a,** whereas the direction of a plane parallel to the viewer-side surface **17b** of the liquid crystal display panel **10b** is represented by a one-dot chain line **70b.** Since the incident face **21a** of the light guide element **20a** is parallel to the viewer-side surface **17a** of the liquid crystal display panel **10a,** the line **70a** is parallel to the incident face **21a.** Similarly, the line **70b** is parallel to the incident face **21b** of the light guide element **20b.** The direction of a plane parallel to the outgoing face **22a** of the light guide element **20a** is represented by a one-dot chain line **71a,** whereas a direction parallel to the outgoing face **22b** of the light guide element **20b** is represented by a one-dot chain line **71b.**

The angle made by the line **70a** and the line **70b** is equal to the angle $\theta$ made by the viewer-side surface **17a** of the liquid crystal display panel **10a** and the viewer-side surface **17b** of the liquid crystal display panel **10b.**

The angle made by the line **70a** and the line **71a** is designated as $\alpha$, and the angle made by the line **70b** and the line **71b** is designated as $\beta$. $\alpha$ and $\beta$ are vertex angles of the triangular prism.

Lengths of the incident faces **21a** and **21b** and the outgoing faces **22a** and **22b** of the light guide elements **20a** and **20b,** in a cross-section perpendicular to the longitudinal directions thereof, are set as follows.

L1: length of the incident face **21a** of the light guide element **20a**

L2: length of the outgoing face **22a** of the light guide element **20a**

L3: length of the incident face **21b** of the light guide element **20b**

L4: length of the outgoing face **22b** of the light guide element **20b**

Where it is set that $\alpha = \beta = \theta/2$, the angle made by the line **70a** and the line **71a** and the angle made by the line **70b** and the line **71b** are equal to each other. Since $\alpha + \beta = \theta$ in this case, the line **71a** is parallel to the line **71b.** This means that the outgoing face **22a** and the outgoing face **22b** are coplanar. Moreover, in the liquid crystal display device **200,** as described above, the end **24a** of the outgoing face **22a** abuts on the end **24b** of the outgoing face **22b.** Therefore, the line **71a** and the line **71b** form one continuous straight line. That is, the outgoing face **22a** and the outgoing face **22b** form one continuous plane. Owing to this, the liquid crystal display device **200** is better-looking and provides a higher-quality image than a display device in which the outgoing faces are not coplanar.

When L1 and L2 are not equal to each other, the image is enlarged or reduced. When L1 < L2, an image formed in the peripheral display region **32a** of the liquid crystal display panel **10a** is enlarged by the light guide element **20a** when displayed on the viewer's side. In this case, in the peripheral display region **32a,** an image needs to be formed in a compressed form as compared with the image formed in a central display region **33a,** which is a region of the display region **31a** other than the peripheral display region **32a.** This incurs trouble and cost. When L1 > L2, an image formed in the peripheral display region **32a** of the liquid crystal display panel **10a** is reduced by the light guide element **20a** when displayed on the viewer's side. Similarly to the case where L1 < L2, this also incurs trouble and cost. A method for enlarging or reducing an image will be described later.

Accordingly, it is preferable that L1 and L2 are equal to each other. In this case, the shape of a cross-section of the light guide element **20a** (cross-section perpendicular to the longitudinal direction) is an isosceles triangle. The overall shape of the light guide element **20a** is an isosceles triangular prism.

For a similar reason, it is also preferable that in the light guide element **20b,** L3 and L4 are equal to each other and the overall shape thereof is an isosceles triangular prism.

Thus, the shapes of the cross-sections of the optimum light guide elements **20a** and **20b** which are perpendicular to the longitudinal directions thereof are mutually similar isosceles triangles.

This is merely an optimum scenario, and it is not absolutely required that $\alpha = \beta = \theta/2$, or L1 = L2 and L3 = L4.

As described below, the volume of the light guide element **20a** is larger than the volume of the light guide element **20b.** As shown in FIG. **16,** L1 > L3 and L2 > L4. As described above, the cross-section of the light guide element **20a** and the cross-section of the light guide element **20b** are of mutually similar isosceles triangles. Therefore, the area size of the cross-section of the light guide element **20a** which is perpendicular to the longitudinal direction thereof is larger than the area size of the cross-section of the light guide element **20b** which is perpendicular to the longitudinal direction thereof. As shown in FIG. **13,** the light guide element **20a** and the light guide element **20b** are both of triangular prisms having approximately the same length in the longitudinal direction thereof. Accordingly, the volume of the light guide element **20a** is larger than the volume of the light guide element **20b.** This occurs because as described above, in the liquid crystal display device **200,** the frame region **32a** of the liquid crystal display panel **10a** overlaps the side face **18b** of the liquid crystal display panel **10b.** Conversely, in the case where the frame region **32b** of the liquid crystal display panel **10b** overlaps the side face of the liquid crystal display panel **10a,** the volume of the light guide element **20b** is larger than the volume of the light guide element **20a.**

For example, the design values of the light guide elements **20a** and **20b** described later as examples are: L1 = L2 = 14.9 mm and L3 = L4 = 10.9 mm. In this case, the volume of the light guide element **20a** is about 1.87 times the volume of the light guide element **20b.**

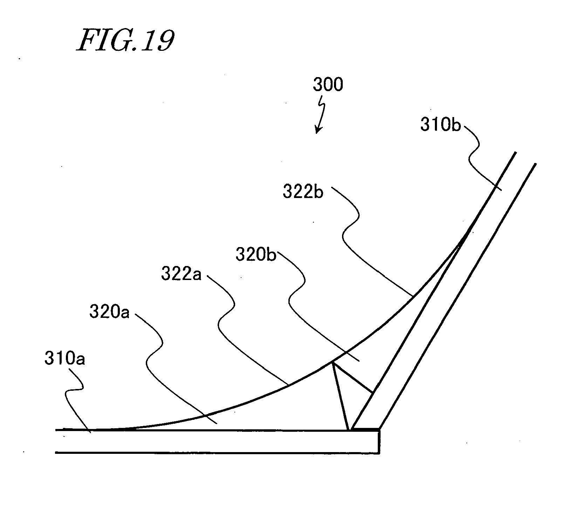

The case where the shape of the light guide elements is a triangular prism is described above, but even where the shape of the light guide elements is not a triangular prism, the volume of one of the light guide elements is larger than the volume of the other light guide element. For example, even in a liquid crystal display device **300** (FIG. **19)** described later in which an outgoing face **322a** of a light guide element **320a** and an outgoing face **322b** of a light guide element **320b** are both a part of a cylindrical surface, the volume of the light guide element **320a** is larger than the volume of the light guide element **320b.**

Note that a region **20c** (dotted area in FIG. **16)** which is surrounded by the following three faces is an ineffective region not contributing to display: the side face **23a** of the light guide element **20a,** the side face **23b** of the light guide element **20b,** and a portion of the viewer-side surface **17b** of the liquid crystal display panel **10b** that corresponds to the frame region **30b.** Therefore, the region **20c** may be a gap; or alternatively, a member formed of a resin material or the like may be placed therein. Still alternatively, a part of the light guide element **20a** or **20b** may be formed so as to protrude into the region **20c.** In this case, the overall shape of such a light guide element is different from the aforementioned isosceles triangular prism. However, the above discussion only intends that the shape of the effective region be an isosceles triangular prism, and the effect of the light guide element is not lost even if the light guide element protrudes into the ineffective region and the overall shape is no longer an isosceles triangular prism.

The design values of the liquid crystal display device **200** are shown below.

$$\alpha = \beta = \theta/2 = 30°$$

$$L1 = L2 = 14.9 \ mm$$

$$L3 = L4 = 10.9 \ mm$$

The width of each of the frame regions **30a** and **30b** is 4 mm.

Now, a liquid crystal display device **200'** according to another embodiment will be shown.

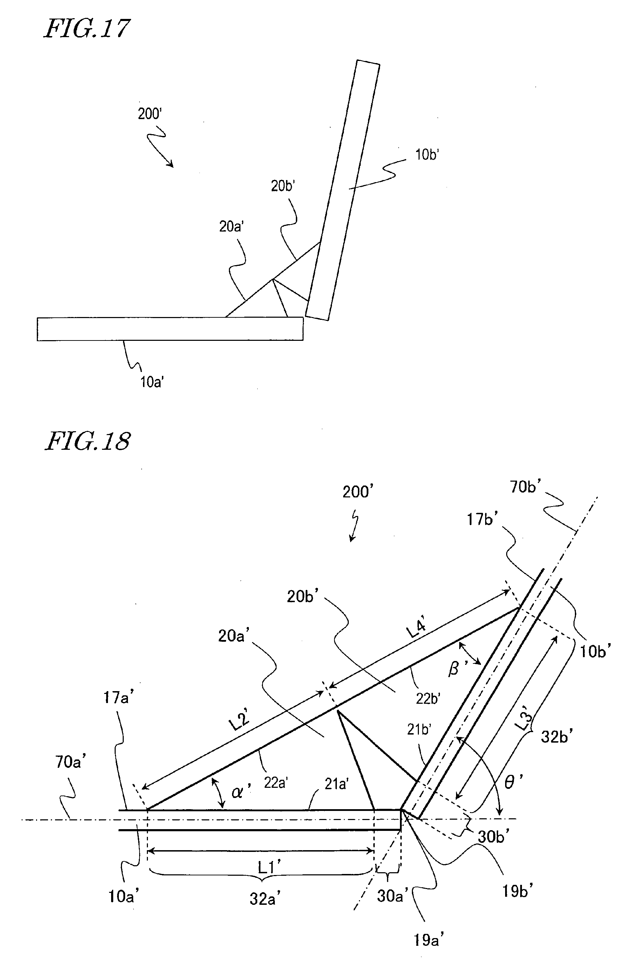

FIG. **17** is a cross-sectional view of the liquid crystal display device **200'** according to an embodiment. The liquid crystal display device **200'** includes liquid crystal display panels **10a'** and **10b'** similar to the liquid crystal display panels **10a** and **10b** of the liquid crystal display device 200, and light guide elements **20a'** and **20b'**. FIG. **18** is an enlarged view of a joint between the liquid crystal display panels **10a'** and **10b'** of the liquid crystal display device **200'**. In the liquid crystal display device **200'**, the liquid crystal display panels **10a'** and **10b'** are disposed at an angle θ' such that viewer-side edges **19a'** and **19b'** thereof abut on each other. Note that the angle θ' is an angle made by a direction **70a'** parallel to a viewer-side surface **17a'** of the liquid crystal display panel **10a'** and a direction **70b'** parallel to a viewer-side surface **17b'** of the liquid crystal display panel **10b'**. The light guide elements **20a'** and **20b'** are disposed respectively on the viewer-side surfaces **17a'** and **17b'** of the liquid crystal display panels **10a'** and **10b'**. The light guide elements **20a'** and **20b'** are disposed on the viewer's side with respect to peripheral display regions **32a'** and **32b'**.

The light guide elements **20a'** and **20b'** have a triangular prism shape, and light going out from the peripheral display regions **32a'** and **32b'** goes out toward the viewer's side by the light guide elements **20a'** and **20b'**. Owing to this, images formed in the peripheral display regions **32a'** and **32b'** are displayed on the viewer's side with respect to the light guide elements **20a'** and **20b'**. Thus, frame regions **30a'** and **30b'** are obscured and a jointless image is displayed.

The liquid crystal display device **200** and the liquid crystal display device **200'** are different from each other in the joint portion of the two display panels. As described above, in the liquid crystal display device **200,** the frame region **30a** of the liquid crystal display panel **10a** overlaps the side face **18b** of the liquid crystal display panel **10b.** In the liquid crystal display device **200',** the viewer-side edges **19a'** and **19b'** of the display panels **10a'** and **10b'** abut on each other.

In the liquid crystal display device **200',** the design values of the light guide elements **20a'** and **20b'** are as follows.

$$\alpha' = \beta' = \theta'/2 = 30°$$

$$L1' = L2' = L3' = L4' = 25.7 \ mm$$

α' and β' are vertex angles of the light guide elements **20a'** and **20b'** having a triangular prism shape. L1' and L2' are respectively lengths of an incident face **21a'** and an outgoing face **22a'** of the light guide element **20a'** in the cross-section, whereas L3' and L4' are respectively lengths of an incident face **21b'** and an outgoing face **22b'** of the light guide element **20b'** in the cross-section. The width of each of the frame regions **30a'** and **30b'** is 4 mm like in the liquid crystal display device **200.**

The volumes of the light guide elements **20a** and **20b** of the liquid crystal display device **200** and the volumes of the light guide elements **20a'** and **20b'** of the liquid crystal display device **200'** can be compared as follows.

$$20a:20a' = 34:100$$

$$20b:20b' = 18:100$$

In the liquid crystal display device **200,** the volumes of the light guide element **20a** and the light guide element **20b** can be reduced to about 1/3 and about 1/5 of those in the liquid crystal display device **200'.** In the liquid crystal display device **200,** the volumes of the light guide elements can be smaller because the frame region of one display panel overlaps the side face of the other display panel. As seen from this, the liquid crystal display device **200,** even though using a smaller amount of the costly material of the light guide elements, provides an equivalent effect to that of the liquid crystal display device **200'** and so is very useful.

In the liquid crystal display device **200',** the viewer-side edges **19a'** and **19b'** of the display panels **10a'** and **10b'** abut on each other, L1' = L2' = L3' = L4', and the light guide elements **20a'** and **20b'** have the same volume. In the liquid crystal display device **200,** L3 and L4 are smaller than L1 and L2, respectively. That is, the volume of the light guide element **20b** is smaller than the volume of the light guide element **20a.** The light guide element **20a** has a smaller volume than those of the light guide elements **20a'** and **20b',** but the light guide element **20b** can have a still smaller volume.

Even the liquid crystal display device **200'** does not require a light guide element of a large area size unlike the conventional display devices described in Patent Documents 1 through 3 mentioned above and so can be produced easily and at low cost. The liquid crystal display device **200** allows the light guide elements to be still smaller. Thus, the liquid crystal display device **200** can further reduce the cost.

In the liquid crystal display device **200,** light-diffusing layers may be provided on the viewer's side with respect to the outgoing faces **22a** and **22b** of the light guide elements **20a** and **20b.** By providing the light-diffusing layers, light going out from the outgoing face is diffused. This provides an effect of widening the viewing angle of the liquid crystal display device **200.** As the light-diffusing layer, any known light-diffusing layer or light-diffusing element is usable. For example, a light-diffusing element such as, for example, a scattering film containing microparticles, a diffuse reflection layer having a surface with minute bumps and dents randomly formed thereon, a prism sheet such as BEF from Sumitomo 3M Limited, or a microlens array can be used.

The outgoing faces **22a** and **22b** of the light guide elements **20a** and **20b** do not need to be planar, and light guide elements having curved outgoing faces can be used. In the liquid crystal display device **200,** cross-sections of the light guide elements **20a** and **20b** (cross-sections perpendicular to the longitudinal directions thereof) are triangular, and the outgoing faces **22a** and **22b** are represented with straight lines in the cross-sections thereof. Alternatively, the outgoing faces may be arced in cross-sections thereof like, for example, the outgoing faces **322a** and **322b** of the light guide elements **320a** and **320b** of the liquid crystal display device **300** shown in FIG. **19.** In this case, the outgoing faces **322a** and **322b** are cylindrical surfaces. Needless to say, the outgoing faces of the light guide elements do not need to be cylindrical surfaces, and can be freely designed to have any shape as long as the thickness thereof increases from the peripheral display region toward the frame region.

In the case where the distance between the liquid crystal layer of the liquid crystal display panel **10a** or **10b** and the light guide element is long, or a light-diffusing layer exists therebetween, an image which is seen through the light guide elements may be blurred occasionally. Therefore, it is preferable that the viewer-side substrates (counter substrates **11a** and **11b)** of the liquid crystal display panels **10a** and **10b,** and the optical film portions **15a** and **15b** provided on the viewer's side with respect to the viewer-side substrates, have a minimum possible thickness (e.g., the thickness of each substrate is 0.3 mm; and the thickness of each optical film portion is 0.1 mm) and have a high transmittance for parallel light (i.e., do not diffuse light much). For a similar reason, it is preferable that the adhesives (including tackiness agents) provided on the viewer's side of each liquid crystal display panel, such as a tacky film included in the optical film portion, are formed of a material containing no light-diffusing particles.

In the liquid crystal display device **200,** a side face **58b** (shown in FIG. **12),** on the side of the liquid crystal display panel **10a,** of the backlight device **50b** which is disposed on the side opposite from the viewer's side with respect to the liquid crystal display panel **10b** is parallel to the viewer-side surface **17a** of the liquid crystal display panel **10a.** In other words, the side face **58b** is formed to be oblique such that the angle made by the side face **58b** and the viewer-side surface **17b** of the liquid crystal display panel **10b** is equal to the angle θ made by the viewer-side surface **17a** and the viewer-side surface **17b.** In addition, a part of the side face **58b** of the backlight device **50b** overlaps the frame region **30a** of the liquid crystal display panel **10a.** Owing to such a structure, the display region **31b** of the liquid crystal display panel **10b** is brought closer to the display region **31a** of the liquid crystal display panel **10a** than in the case where the side face **58b** is not formed to be oblique. This can reduce the volume of the light guide element, and so is effective for cost reduction. Note that the volume of the light guide element can be reduced as described above even if the side face of the backlight device is not formed to be oblique in this manner.

In the case where a display panel not having a backlight device is used as the display panel, a part of a side face of the display panel can be cut obliquely as the side face **58b** of the backlight device **50b.** Thus, the display regions of the display panels can be made closer to each other, and thus a similar effect as above can be provided.

Now, a structure for obtaining uniform display will be described. First, uniformization of luminance will be described.

Among images formed on the liquid crystal display panels **10a** and **10b,** the images which are formed in the peripheral display regions **32a** and **32b,** on which the light guide elements **20a** and **20b** are disposed, go through the light guide elements **22a** and **22b** before being displayed on the viewer's side. By contrast, the images which are formed in the central display regions **33a** and **33b,** which are regions of the display regions **31a** and **31b** other than the peripheral display regions **32a** and **32b,** are displayed on the viewer's side without going through the light guide elements. Therefore, there occurs a difference in luminance between the images which are formed in the peripheral display regions **32a** and **32b** and displayed through the light guide elements and the images which are formed in the central display regions **33a** and **33b** and displayed on the viewer's side. For example, when the length L1 of the incident face **21a** of the light guide element **20a** in the cross-section is greater than the length L2 of the outgoing face **22a** in the cross-section, the image which is formed in the peripheral display region **32a** is reduced through the light guide element **20a.** This increases the luminance. By contrast, when L1 < L2, the image which is formed in the peripheral display region **32a** is enlarged through the light guide element **20a.** This decreases the luminance. When L3 > L4, substantially the same occurs as when L1 > L2; and when L3 < L4, substantially the same occurs as when L1 < L2. As described above, in the liquid crystal display device **200,** the light guide elements **20a** and **20b** each have a light guide portion including a transparent portion having a metal portion on a side face thereof, and the light incident on the transparent portion is guided while being reflected by the metal portion. Each time the light is reflected by the metal portion, a part of the light is absorbed. This occurs regardless of which of L1 or L2, or which of L3 or L4, is greater. This also causes a difference in luminance between the regions in which the light guide elements **20a** and **20b** are provided and the regions with no light guide elements.

Such a difference in luminance can be alleviated by allowing the luminance of the images formed in the peripheral display regions **32a** and **32b** to be different from the luminance of the images formed in the central display regions **33a** and **33b.**

For example, when the luminance of the images displayed in the regions in which the light guide elements **20a** and **20b** are provided is lower than the luminance of the images displayed in the regions in which the light guide elements **20a** and **20b** are not provided (in the above, when L1 < L2 or L3 < L4), the luminance difference can be alleviated by allowing the luminance of the images formed in the peripheral display regions **32a** and **32b** to be higher than the luminance of the images formed in the central display regions **33a** and **33b.**

For the liquid crystal display device **200,** the following two methods can be adopted.

Method a: The transmittance of the pixels provided in the central display regions **33a** and **33b** is decreased.

Method *b*: The intensity of light emitted toward the peripheral display regions **32a** and **32b** is made higher than the intensity of the light emitted toward the central display regions **33a** and **33b.**

Method a can be easily realized by adjusting the voltages supplied to the pixels. Method b can be realized by, for example, allowing the intensity of the light which is emitted from the backlight devices **50a** and **50b** toward the pixels arrayed in the peripheral display regions **32a** and 32b to be higher than the intensity of the light which is emitted toward the pixels arrayed in the central display regions **33a** and **33b.** In the case where cold cathode fluorescent tubes are provided as the backlight devices **50a** and **50b,** a group of the cold cathode fluorescent tubes disposed in correspondence to the peripheral display regions **32a** and **32b** may be lit brighter than another group of the cold cathode fluorescent tubes (group of the cold cathode fluorescent tubes disposed in correspondence to the central display regions **33a** and **33b).** Such a method is also applicable to the case where light-emitting diodes (LEDs) are provided as the backlight devices **50a** and **50b.** Needless to say, methods a and b may be combined for uniformization of luminance.

The difference in luminance also occurs between portions of the light guide elements **20a** and **20b** on the side of the peripheral display regions **32a** and **32b** and portions of the light guide elements **20a** and **20b** on the side of the frame regions **30a** and **30b.** When this luminance difference is large, the viewer may occasionally be given unnaturalness. The light guide elements **20a** and **20b** have a triangular prism shape, and so the distance between the outgoing faces **22a** and **22b** and the incident faces **21a** and **21b** increases from the peripheral display regions **32a** and **32b** toward the frame regions **30a** and **30b.** Namely, the light guide path becomes longer from the peripheral display regions **32a** and **32b** toward the frame regions **30a** and **30b.** As described above, as the light guide path is longer, the number of times of light reflection by the metal layers **44** is increased and so the transmittance is decreased. Therefore, the transmittance of the light guide elements **20a** and **20b** is decreased from the peripheral display regions **32a** and **32b** toward the frame regions **30a** and **30b.** This causes a difference in transmittance between the portions of the light guide elements **20a** and **20b** on the side of the peripheral display regions **32a** and **32b** and the portions of the light guide elements **20a** and **20b** on the side of the frame regions **30a** and **30b.** This difference in transmittance causes the luminance difference. When the reflectance by the metal layers **44** is low, the transmittance difference between the portions of the light guide elements **20a** and **20b** on the side of the peripheral display regions **32a** and **32b** and the portions of the light guide elements **20a** and **20b** on the side of the frame regions **30a** and **30b** is increased, which increases the luminance difference.

Such a luminance difference can be solved and the luminance can be uniformized by continuously changing the transmittance of the pixels or the luminance of the backlight devices in the peripheral display regions **32a** and **32b.**

In the case where a self-light-emitting type display panel such as a plasma display panel (PDP) or an organic EL display panel (OLED) is used as the display panel, the luminance of pixels provided in the display region having no light guide elements may be made relatively small.

Even in the case where the transmittance of the light guide element varies depending on the wavelength of the light entering the light guide element, namely, even in the case where the color of the transmitted light is changeable, the hue can be adjusted by method a or method b above.

Now, image uniformization will be described.

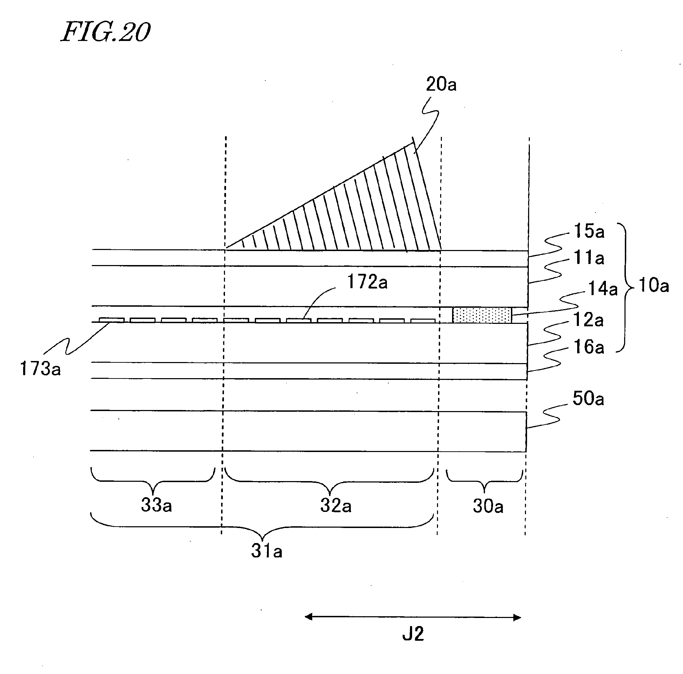

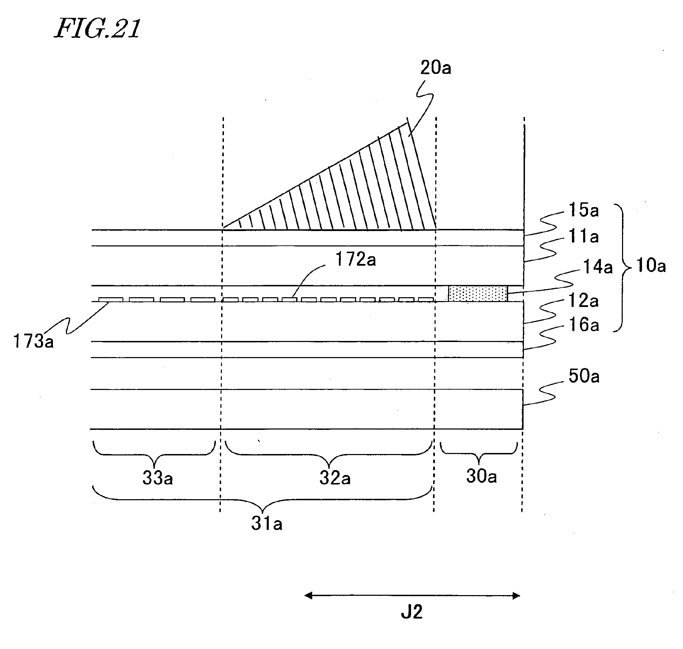

As described above, when L1 < L2 in the light guide element **20a,** an image which is formed in the peripheral display region **32a** is enlarged by the light guide element **20a** along the second axis **J2.** Therefore, in order to realize normal display, it is preferable that the image which is formed in the peripheral display region **32a** is compressed in advance relative to the images which are formed in the central display regions **33a** and **33b,** in accordance with a ratio of enlargement by the light guide element **20a.** For displaying an image in a compressed form, there are the following two methods. The two methods will be described with reference to FIG. **20** and FIG. **21.** FIG. **20** and FIG. **21** are schematic views illustrating methods 1 and 2 described below, respectively.

Method 1: As shown in FIG. **20** regarding the liquid crystal display panel **10a,** while the pitch of pixels **173a** (pixels provided in the central display region **33a**) and pixels **172a** (pixels provided in the peripheral display region **32a**) is kept constant across the entire display region **31a** of the liquid crystal display panel **10a** (peripheral display region **32a** and central display region **33a**), a compressed image is formed in the peripheral display region **32a** through signal processing. In other words, the display signals to be supplied to the plurality of pixels provided in the peripheral display region **32a** are compressed along the second axis **J2.** At this time, the display signals to be supplied to the pixels **172a** provided in the peripheral display region **32a** are compressed in accordance with the ratio of enlargement by the light guide element **20a.**

Method 2: As shown in FIG. **21** regarding the liquid crystal display panel **10a,** the pitch of the pixels **172a** arrayed in the peripheral display region **32a** is made narrower (compressed) than the pitch of the pixels **173a** arrayed in the other region (central display region **33a**), and a compressed image is formed without performing signal processing. Method 2 does not need any special signal processing, but requires a specially-designed display panel to be produced in advance and so has problems of being poor in versatility, being costly and the like.

By contrast, method 1 requires signal processing but has an advantage in that a general display panel can be used. Method 1 can be implemented by software, for example. In the case where the outgoing face **22a** of the light guide element **20a** is planar (represented with a straight line in the cross-section), the image is uniformly enlarged along the second axis **J2** and so the image compression and display signal compression can be performed uniformly. Thus, method 1 has an advantage that signal processing can be performed simply. In the case where a light guide element having a curved outgoing face such as the light guide element **320a** or **320b** of the liquid crystal display device **300** shown in FIG. **19** is used, the image may be compressed according to the ratio of enlargement by the light guide element.

Described above are the methods for forming an image in a compressed form in the peripheral display region **32a** as compared with the image in the central display region **33a** in the case where L1 < L2 and the image formed in the peripheral display region **32a** is to be enlarged by the light guide element **20a.** In the case where L1 > L2, the image formed in the peripheral display region **32a** is reduced by the light guide element **20a** along the second axis **J2.** Therefore, it is preferable that the image which is formed in the peripheral display region **32a** is enlarged in advance relative to the images which are formed in the central display regions **33a** and **33b.** The image can be enlarged by a method reverse to the method for reduction described above.

Similarly, as for the light guide element **20b,** an image which is formed in the peripheral display region **32b** may be reduced or enlarged along the third axis **J3** by the above-described methods in the cases where L3 < L4 and L3 > L4, respectively.

In the liquid crystal display device **200,** the light guide elements **20a** and **20b** have an isosceles triangular prism shape. That is, the cross sections of the light guide elements **20a** and **20b** that are perpendicular to their longitudinal directions thereof are isosceles-triangular, so that L1 = L2 and L3 = L4. Therefore, images formed in the peripheral display regions **32a** and **32b** are neither enlarged nor reduced by the light guide elements **20a** and **20b.** Thus, there is no need to enlarge or reduce the images as described above. However, when there is a conspicuous difference in luminance due to a part of the light being absorbed by the metal portions of the light guide elements **20a** and **20b,** it is preferable to alleviate the difference in luminance by the aforementioned method a or b as necessary. In addition, due to the difference in volume between the light guide elements **20a** and **20b,** a difference in luminance may possibly occur between an image displayed on the outgoing face **22a** and an image displayed on the outgoing face **22b.** In this case also, it is preferable to alleviate the difference in luminance by the aforementioned method a or b as necessary.

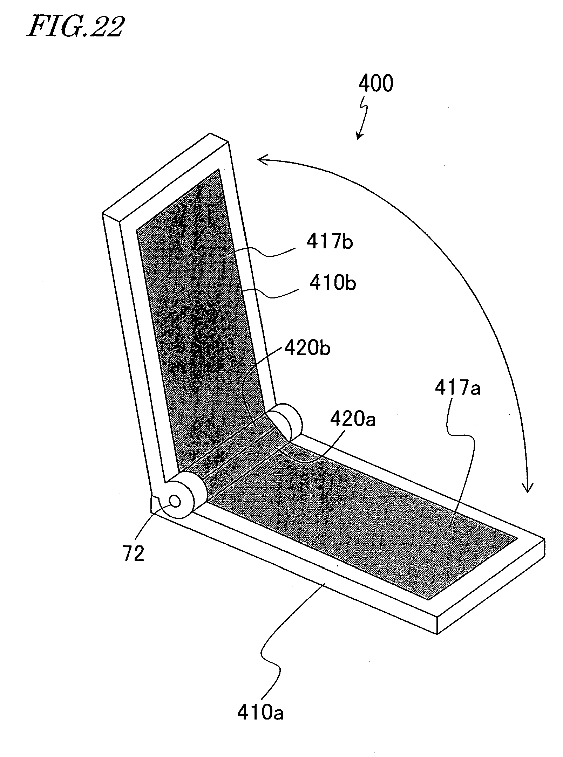

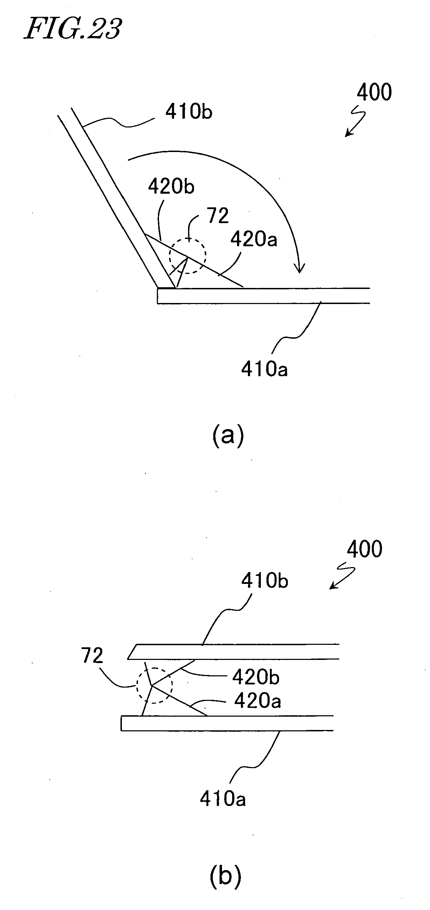

The structure of the liquid crystal display device 200 is applicable to a display device including a plurality of display panels disposed at a prescribed angle, but is also applicable to a display device which allows the angle made by the display panels to vary. In a display device **400** shown in FIG. **22,** a contact portion between light guide elements **420a** and **420b** respectively provided on viewer-side surfaces **417a** and **417b** of the display panels **410a** and **410b** adjoining each other is a movable portion which is rotatable around an axis **72.** FIG. **23** shows the details of the movable portion. FIG. **23** shows enlarged cross-sectional views of the movable portion. FIG. **23(a)** shows an open state, and FIG. **23(b)** shows a closed state. By adopting such a structure, the angle made by the adjoining display panels **410a** and **410b** can be made variable. Moreover, the display device can be opened or closed while keeping the joint between the display panels obscure. The display device **400** like this also uses small-sized light guide elements and so allows the joint to be obscure at low cost.

Accordingly, by adopting the structure of the liquid crystal display device **400,** a display device including two screens such as, for example, a mobile phone, a game machine, an electronic book or the like can display jointless images at low cost. Thus, even a small-sized electronic device can have a larger-screen display device mounted thereon than the conventional device.

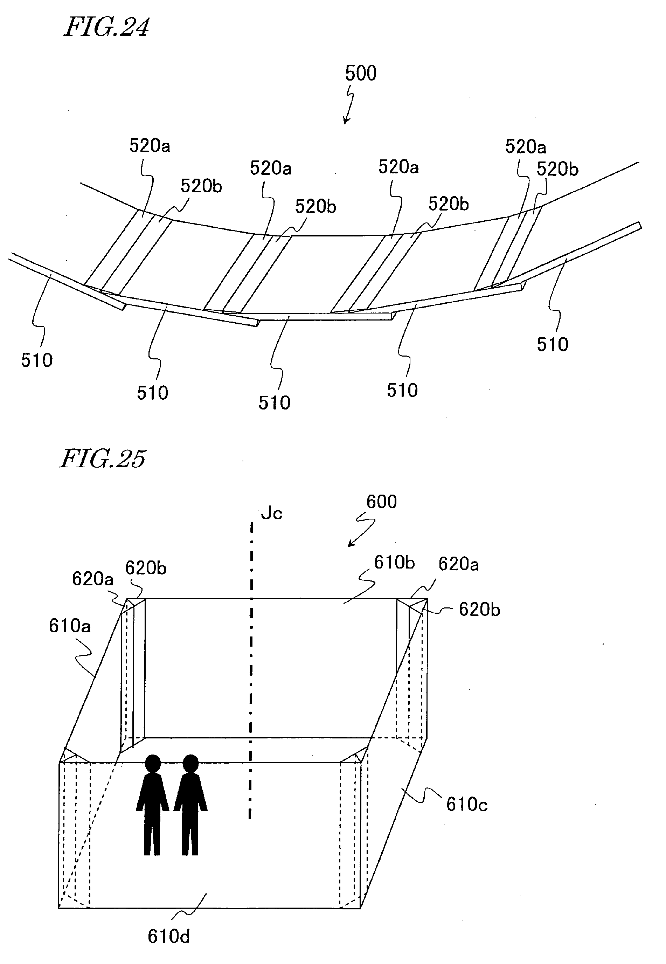

The liquid crystal display device **200** includes two display panels. Applying the concept of the liquid crystal display device **200,** a larger number of display panels may be tiled as in a display device 500 shown in FIG. **24.** FIG. **24** is a perspective view of the display device **500** including a plurality of display panels. The display device **500** shown in FIG. **24** includes a plurality of display panels **510,** and the display panels **510** adjoin each other. Regarding two adjoining display panels, a frame region of one display panel overlaps a side face of the other display panel, such that an angle made by a viewer-side surface of one display panel and a viewer-side surface of the other display panel is greater than 0° and less than 180° (e.g., 10°). Even the display device **500** of a curved surface type can display an image having joints thereof obscured, by including light guide elements **520a** and **520b** at ends of the display panels adjoining each other. Even such a type of display device can display a jointless image by small-sized light guide elements, and so can reduce cost.

Moreover, at least three display panels may be disposed in an annular shape around one axis, so that a display device having the entire inner surface as a display plane can be realized. For example, in a display device **600** shown in FIG. **25,** four display panels **610a, 610b, 610c** and **610d** are disposed in an annular shape around a center axis **Jc,** with light guide elements **620a** and **620b** being disposed at corners of the display device. Even such a type of display device can display a jointless image by small-sized light guide elements, and so can reduce cost.

Applying the concept of the display device **600,** display panels may be disposed along the inner walls of a room, with light guide elements being provided in correspondence to the corners. In this manner, the entire inner walls of the room can be covered with a jointless display device. By covering the entire inner walls with a jointless display device, an ultra high level of sensation of reality, which cannot be provided by a single display panel, can be provided.

Now, other embodiments of large-sized liquid crystal display device in which a plurality of liquid crystal display devices **100a** are tiled will be described.

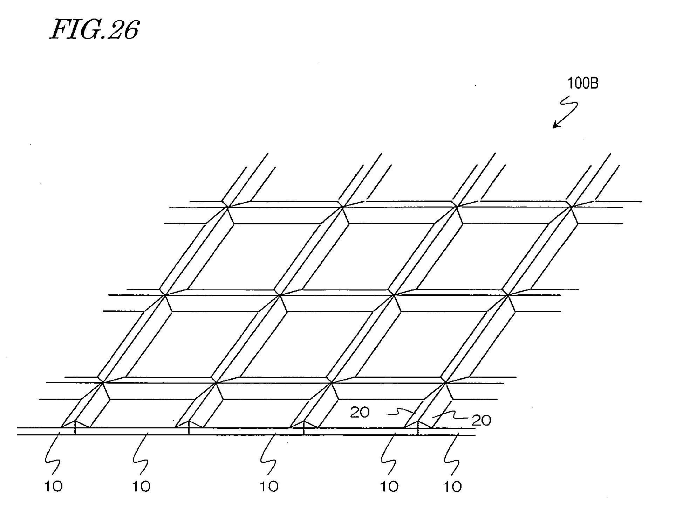

As described above, the liquid crystal display device **100A** (FIG. **3)** including a plurality of liquid crystal display devices **100a** arranged in a line realizes display having a joint thereof obscured, by including light guide elements **20** on the sides of adjoining liquid crystal display devices **100a.** A liquid crystal display device **100B** shown in FIG. **26** is obtained by arranging, in a matrix, liquid crystal display devices having a light guide element **20** on each of the four sides thereof. In the liquid crystal display device **100B,** the light guide element **20** are provided on each of the four sides of the liquid crystal display device **100a,** and so the entirety of the liquid crystal display device **100B** realize display having joints thereof obscured.

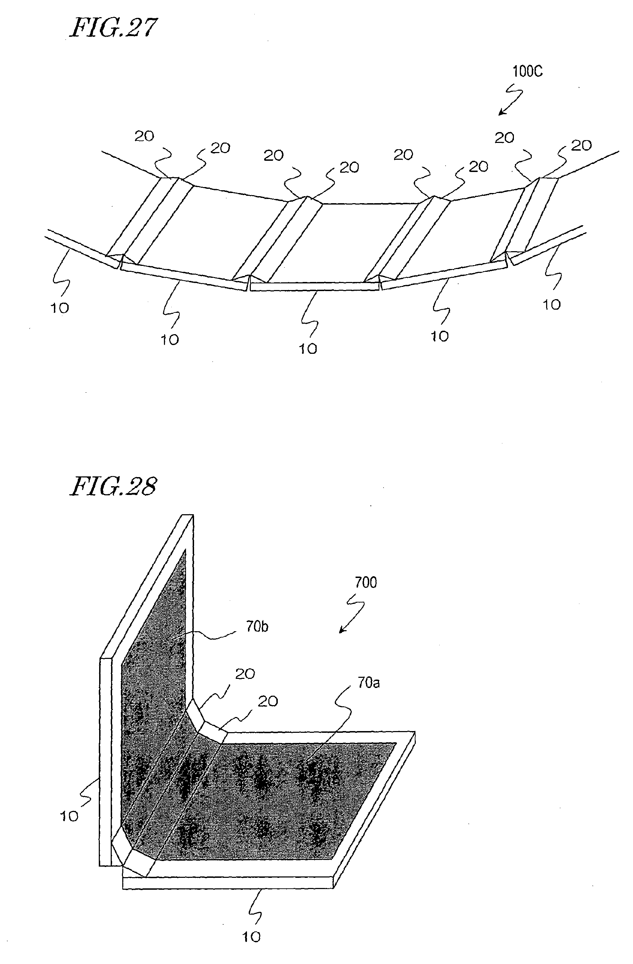

As a liquid crystal display device **100C** shown in FIG. **27,** a plurality of liquid crystal display panels **10** may be disposed at an angle of, for example, 10 degrees such that sides of the liquid crystal display panels **10** having the light guide elements thereon adjoin each other. This way, a jointless curved display device can be realized. Needless to say, there is no limitation on the angle made by the display planes of the plurality of liquid crystal display devices **10,** as long as the sides with the light guide elements **20** adjoin each other. It is preferable that the angle is less than 180° for making the vertex angles of the light guide elements **20** inconspicuous. On principle, jointless display can be provided even with an angle of 180° or greater.

In FIG. **3,** FIG. **26** and FIG. **27,** the backlight device **50** is omitted. In the case where a plurality of liquid crystal display devices **100a** are tiled, the backlight device **50** may be provided for each of the liquid crystal display devices **100a.** Alternatively, the backlight device **50** may be provided commonly to a part of, or the entirety of, the plurality of liquid crystal display devices **100a** included in the liquid crystal display device obtained by the tiling. Needless to say, when self-light-emitting elements such as organic EL display panels or the like are used instead of the liquid crystal display panels **10,** the backlight device **50** is not necessary.

Now, with reference to FIG. **28** through **31,** various specific examples of the display device according to embodiments of the present invention will be further described.

For example, as in a display device **700** shown in FIG. **28,** two display panels **10** may be disposed in an L shape at an angle of 90 degrees such that edges (sides) thereof having light guide elements **20** thereon abut on each other. Owing to this, a display having a jointless L-shaped display region (display regions **70a** and **70b)** can be realized. This is applicable to display devices of unconventional designs, for example, a digital photo frame stand, an onboard information display device and the like. Needless to say, the angle made by the display planes of the two display panels is not limited to 90 degrees.

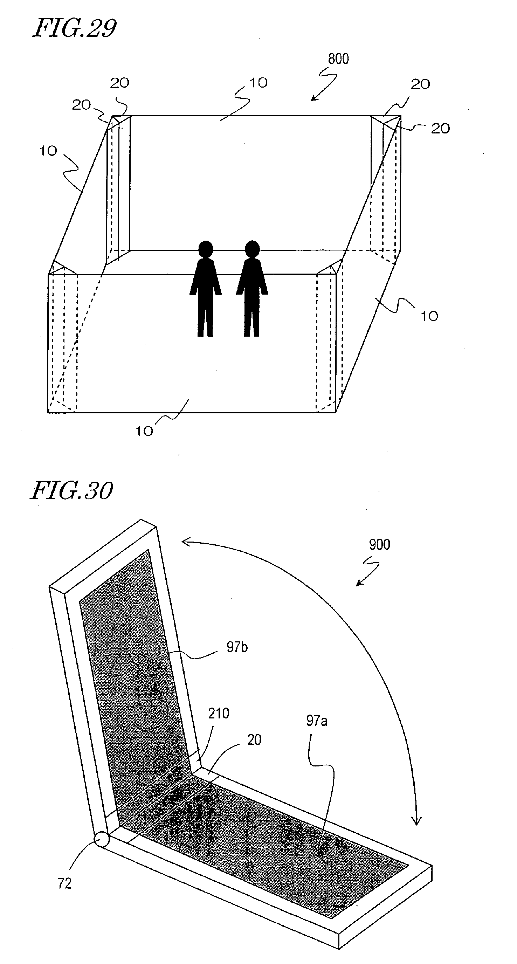

At least three display panels **10** may be disposed in an annular shape around one axis, so that the entire inner surface can act as a display plane. For example, as in a display device **800** shown in FIG. **29,** four display panels **10** may be disposed in an annular shape along the inner walls of a room, with light guide elements **20** being provided in correspondence to the corners. In this manner, the entire inner walls of the room can be covered with a jointless display device. By covering the entire inner walls with a jointless display device, a display device which realizes an ultra high level of sensation of reality, which cannot be realized by a single display panel, can be provided. Needless to say, in the case where the ceiling and the floor are also used for the display device, the level of sensation of reality is improved. Instead of the display panels **10**, the liquid crystal display devices **100a** shown in FIG. **1** may be used.

As in a display device **900** shown in FIG. **30,** a contact portion between light guide elements of display panels adjoining each other may be a movable portion which is rotatable around an axis **72.** In this case, the angle made by adjoining display planes **97a** and **97b** can be made variable. With such a structure, a mobile phone, a game machine, an electronic book or the like including two screens can provide jointless display. As can be seen from this, this structure allows even a small-sized device to have a large-screen device mounted thereon and so is very useful.

In general, in order to normally display an image in the display devices **700, 800** and **900** described above, the image needs to be compressed (or enlarged) for display as described above. However, there are cases where, as in the display device **200'** shown in FIG. **17,** the light guide elements **20a'** and **20b'** having a generally isosceles triangular cross-section can be used depending on the angle made by the display panels **10** adjoining each other. In this case, the incident face and the outgoing face of each light guide element have substantially the same length, and so the image is displayed with the original size without being enlarged or reduced.

In the case where a plurality of liquid crystal display panels are disposed at an angle with respect to each other as in the liquid crystal display devices **700, 800** and **900** described above, two adjoining liquid crystal display panels may be disposed such that a frame region of one liquid crystal display panel overlaps a side face of the other liquid crystal display panel as in the liquid crystal display devices **200, 300, 400, 500** and **600.** This is preferable because smaller light guide elements can be used.

As described above, as a light guide element, an optical fiber face plate or a laminate of at least two types of light-transmissive layers having different refractive indices may be used.

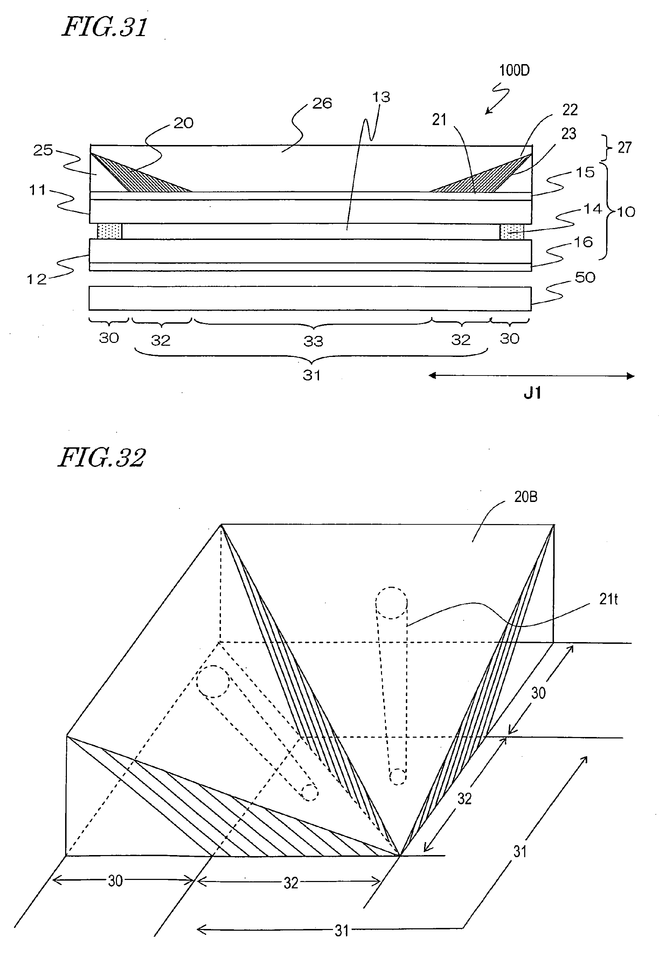

A case where an optical fiber face plate is used as a light guide element will be described. An individual optical fiber includes core and cladding, and the refractive index of the core is higher than the refractive index of the cladding. FIG. **31** shows the liquid crystal display device **100D** using optical fiber face plates as the light guide elements **20.** FIG. **31** is a cross-sectional view of the liquid crystal display device **100D.** In the cross-sectional view of FIG. **31,** optical fibers are arranged parallel to the side face **23** of each light guide element **20.** Light incident on the light guide element **20** through the incident face **21** is propagated in the optical fibers parallel to the side face **23** and goes out toward the viewer's side through the outgoing face **22.** The outgoing face **22** is provided so as to overlap the frame region **30** of the liquid crystal display panel **10,** and so the liquid crystal display device **100D** can utilize, for display, a region of the liquid crystal display panel **10** that corresponds to the frame region **30.**

The optical fiber face plate to be used as the light guide element **20** can be produced by cutting a plate-shaped optical fiber face plate into a triangle prism, such that the incident face and the outgoing face are oblique with respect to the length direction of the optical fibers. For example, an optical fiber face plate formed of quartz (e.g., including core having a refractive index of 1.8 and cladding having a refractive index of 1.5) can be preferably used. Needless to say, as the refractive index difference between the core and the cladding is larger, the numerical aperture (NA: Numerical Aperture) of the optical fibers is larger and the light transmittance is higher. This is preferable, but there is no specific limitation on the refractive indices of the core and the cladding. There is no specific limitation on the material of the optical fibers, and a transparent resin material such as an acrylic resin or the like may be used. In order to prevent the displayed image from being blurred, it is more preferable to use a fiber face plate including a light absorber which prevents light leaking from the core from being conveyed to an adjoining core.

Corners of the liquid crystal display panel in the case where optical fiber face plates are used as the light guide elements **20** of the liquid crystal display device **100B** shown in FIG. **26** will be described. FIG. **32** is an enlarged view of a corner of the liquid crystal display panel in this case. The light guide element for the corner is produced, for example, as schematically shown in FIG. **32,** using a fiber **21t** having a gradually increasing diameter from the incident face toward the outgoing face. Such a tapered light guide element **20B** may be produced as follows. A general non-tapered fiber face plate is stretched by heating such that the diameter of each fiber is changed in accordance with the position, and such a stretched fiber face plate is cut into the light guide element **20B.**

The light guide element **20B** is formed such that cross-sections along lines respectively perpendicular to each of two sides which form an angle and are perpendicular to each other, and a cross-section along a line equally dividing the angle into two (hatched portions in FIG. **23)** has a shape fulfilling the above-described conditions (here, such a shape is a triangle).

Like the liquid crystal display device **100a,** the liquid crystal display device **100D** does not include a light guide element in a majority of the display region **31** excluding the part **32** of the peripheral display region. Accordingly, the liquid crystal display device **100D** does not need an optical fiber face plate of a large area size, and so has an advantage of being produced easily and at low cost. The liquid crystal display device **100D** can realize a super-large-screen display device by tiling, and also can be disassembled for easy transportation and so has an advantage of being handled easily. Thus, the liquid crystal display device **100D** that uses an optical fiber face plate as a light guide element is also advantageous.

The liquid crystal display device **100D** may further include a light-transmissive cover for covering the display region of the liquid crystal display panel **10** and the outgoing faces **22** of the two light guide elements **20.** A cover **26** and the light guide elements **20** are fixed to the surface of the liquid crystal display panel **10** with a transparent adhesive layer not shown. The light guide elements **20** are further fixed by resin layers **25** formed between the side faces **23** and the surface of the liquid crystal display panel **10.** The resin layers **25** may be omitted, but the light guide elements **20** can be fixed more stably with the resin layers **25.** The cover **26** is fixed to the outgoing face **22** of each light guide element **20** by an adhesive layer. The adhesive layer between the light guide element **20** and the liquid crystal display panel **10** is not absolutely necessary. The light guide element **20** and the liquid crystal display panel **10** may be fixed to each other by an air layer provided therebetween.

The light guide elements **20,** the cover **26** and the resin layers **25** provided on the surface, on the viewer's side, of the liquid crystal display panel **10** are collectively referred to as a "light guide sheet **27"** occasionally. By providing the cover **26** and the resin layers **25** in the form of a sheet having a flat surface, the light guide elements **20** and the display plane of the liquid crystal display panel **10** can be protected. Since this flattens a surface of the liquid crystal display device **100D,** the liquid crystal display device **100D** appears more natural. There is another advantage that any stain on the surface can be wiped out more easily. The cover **26** is, for example, a resin plate (e.g., an acrylic resin plate) pre-molded so as to be aligned to the shape of the display plane of the liquid crystal display panel **10** and the light guide elements **20.**

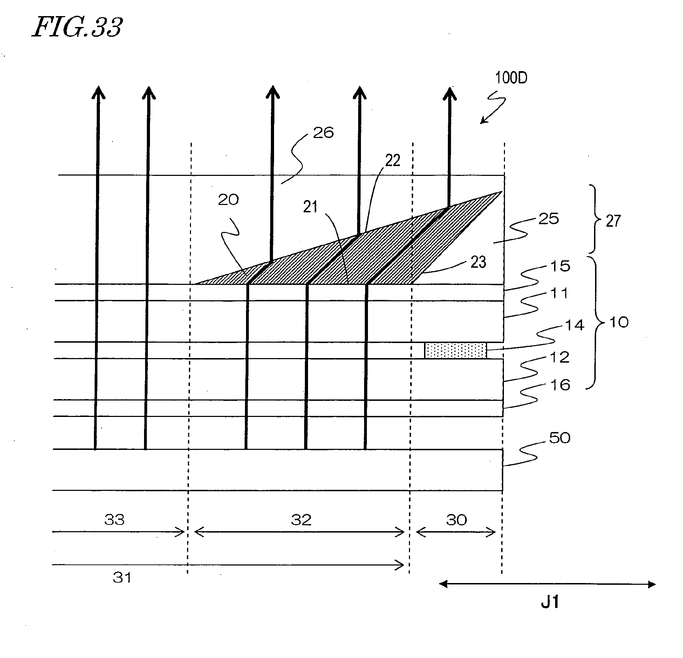

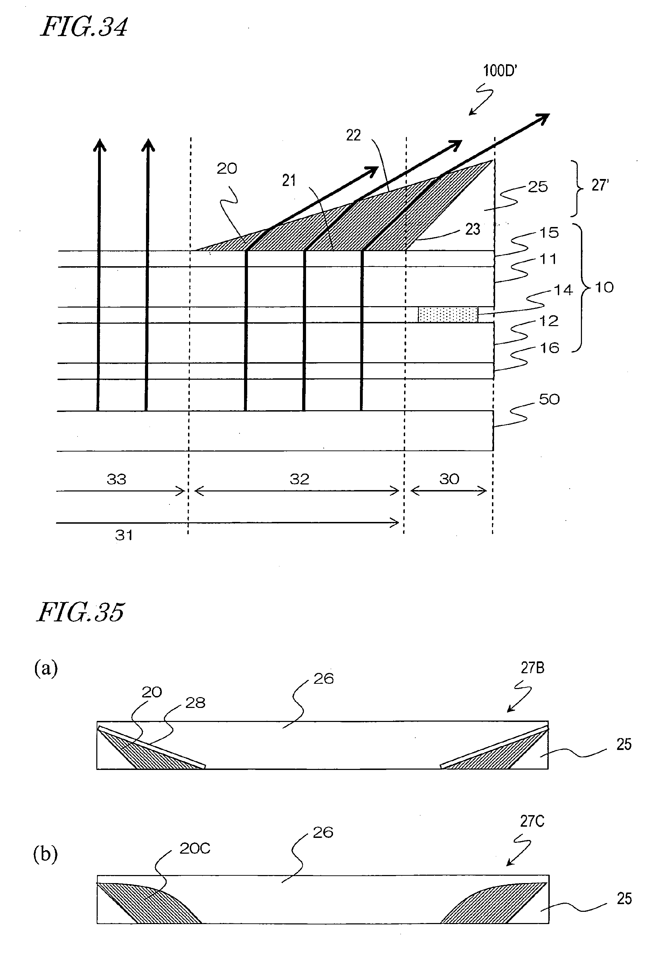

The cover **26** provides an advantage of improving the luminance on a front surface. With reference to FIG. **33** and FIG. **34,** the functions of the cover **26** will be described.

A liquid crystal display device **100D'** shown in FIG. **34** includes an optical sheet **27'** with no cover **26,** instead of the light guide sheet **27** of the liquid crystal display device **100D** shown in FIG. **33.**

As shown in FIG. **34,** light propagated in the light guide element **20** is refracted in accordance with the refractive index difference between the outgoing side **22** and the outside. When there is no cover, the light is refracted in accordance with the ratio of the refractive index of the light guide element **20,** for example, the refractive index of 1.8 of the core of the optical fiber, and the refractive index 1.0 of air. As represented by the thick arrows in FIG. **34,** the light goes out in a direction largely inclined with respect to the front direction (direction of the normal with respect to the display surface of the liquid crystal display panel **10).** As a result, the luminance on the front surface of the liquid crystal display device **100D'** is decreased. When there no cover, it is preferable to provide a reflection preventive film on the optical fiber face plate and on the display plane of the liquid crystal display panel **10.**

By contrast, when the cover **26** is provided as shown in FIG. **33,** the light is refracted on the outgoing face **22** in accordance with the ratio of the refractive index of the light guide element **20** and the refractive index of the cover **26.** Accordingly, the amount of light going out in the front direction is larger than in the case with no cover **26.** In the case where the cover **26** is formed of a material having the same refractive index as that of the core of the optical fiber, the light is not refracted on the outgoing interface, and so the reduction of the luminance on the front surface is minimum.

Instead of the light guide sheet **27** included in the liquid crystal display device **100D** shown in FIG. **31,** a light guide sheet **27B** shown in FIG. **35 (a)** or a light guide sheet **27C** shown in FIG. **35(b)** may also be used.

The light guide sheet **27B** shown in FIG. **35(a)** includes light-diffusing layer **28** formed on the outgoing face of each light guide element **20.** The light-diffusing layer **28** provides an effect of diffusing the light going out from the outgoing face and thus widening the viewing angle. As the light-diffusing layer **28,** any known light-diffusing layer or a light-diffusing element is usable. For example, a light-diffusing element such as, for example, a scattering film containing microparticles such as a diffusing adhesive sheet produced by Tomoegawa Co., Ltd.; a diffusing layer having a surface with minute bumps and dents randomly formed thereon provided by anti-glare processing by Nitto Denko Corporation or the like; a prism sheet such as BEF from Sumitomo 3M Limited or the like; or a microlens array can be used. Needless to say, use of the light-diffusing element is not limited to independent use of one type of light-diffusing element, and a plurality of techniques may be used in combination. For example, a prism sheet and a diffusing adhesive sheet may be combined.

When the light-diffusing layer **28** is provided, the light is diffused in the front surface on the outgoing face of the light guide element **20.** This provides an effect of decreasing the reduction in the luminance on the front surface described above. Accordingly, it is preferable to provide the light-diffusing layer **28** even where the cover **26** is not provided. The light-diffusing layer **28** may be provided so as to cover the display region in addition to the outgoing face of the light guide element **20.**

As in the light guide sheet **27C** shown in FIG. **35(b),** light guide elements **20C** having a curved surface may be used. The light guide elements **20C** may have any shape as long as the thickness thereof increases toward the frame region of the liquid crystal display panel **10.**

It is preferable to further provide a reflection preventive film on the cover **26.** The reflection preventive film can reduce the reflection of external light by the surface and thus to improve the visibility. As the reflection preventive film, a film coated with a low refractive index resin such as a magnesium fluoride ($MgF_2$) thin film, a fluorine-added acrylic resin film or the like; a moth-eye reflection preventive film having bumps and dents of a sub-wavelength order on a surface for reducing the reflection by the surface; or the like is usable.

In the case where the distance between the liquid crystal layer **13** (see FIG. **31)** of the liquid crystal display panel **10** and the light guide element **20** is long, or the light-diffusing layer **28** exists therebetween, an image which is seen through the light guide element **20** may be blurred occasionally. Therefore, it is preferable that the viewer-side substrate (counter substrate) **11** of the liquid crystal display panel **10,** and the optical film portion **15,** have a minimum possible thickness (e.g., the thickness of the substrate **11** is 0.3 mm; and the thickness of the optical film portion **15** is 0.1 mm) and have a high transmittance for parallel light (.i.e., do not diffuse light much). For a similar reason, it is preferable that the adhesives (including tackiness agents) provided on the viewer's side of the liquid crystal display panel **10,** such as a tacky film included in the optical film portion **15,** are formed of a material containing no light-diffusing particles.

As described above, the sheet laminate **80** shown in FIG. **5** including a plurality of light-transmissive layers is also usable as the light guide element **20.**

The sheet laminate **80** is a laminate including at least two types of light-transmissive layers having difference refractive indices. The light-transmissive layers are stacked parallel to each other in a direction perpendicular to a length direction (propagation direction of light). Like each of the light guide element **20** shown in FIG. **1,** the sheet laminate **80** is disposed such that the length direction of the light-transmissive layers **83** and **84** matches an inclining direction of a line connecting an end of the display region **31** and an end of the sheet laminate (i.e., an end of the display device). Thus, the sheet laminate **80** acts as the light guide element **20.**

The sheet laminate **80** can be easily produced as follows.

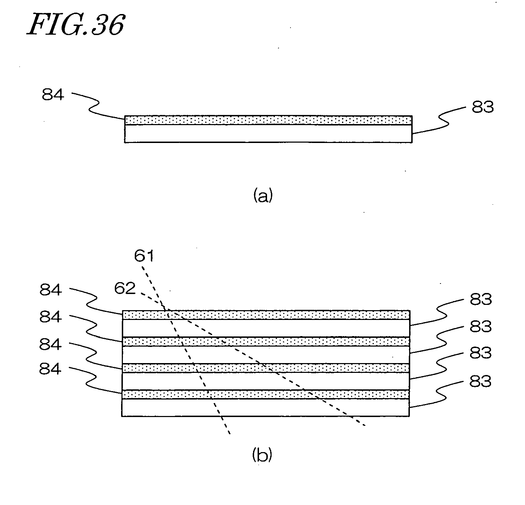

As shown in FIG. **36(a),** on one surface of the substrate **83** formed of a light-transmissive material such as an acrylic resin or glass, a low refractive index resin containing a fluorine-based compound, having a lower refractive index than that of the substrate **83,** such as Opstar (trade name) produced by JSR or the like is applied. The resultant substance is dried and cured. Thus, the substrate **84** is formed. Next, a plurality of substrates **83** and a plurality of substrates **84** are stacked with tacky or adhesive layers being interposed therebetween, and then are cured so that the layers are not delaminated. As the tacky or adhesive material, a resin material such as a thermosetting resin, a thermoplastic resin, an ultraviolet-curable resin or the like is usable, for example. It is preferable that the thickness of the tacky or adhesive layers is as small as possible in the range in which the layers have a high light transmissivity, low light scattering characteristics and a sufficient level of strength after being cured. In the case where the substrates **83** or the substrates **84** are tacky or adhesive, there is no particular need to separately provide such tacky or adhesive layers.

Next, as shown in FIG. **36(b),** the laminate obtained as described above is cut, as represented by dashed lines **61** and **62,** obliquely with respect to the surfaces of the light-transmissive layers **83** and **84.** The cut surfaces are polished when necessary to improve the external appearance. Thus, the sheet laminate **80** shown in FIG. **5** is obtained.

The direction of cutting is a parameter which is determined based on the width of the non-display region **30** and the area size of the region **32** (see, for example, FIG. **33)** in which the sheet laminate **80** is to be located. The angle made by the dashed line **61** and the direction of the surfaces of the substrates **83** and **84** was set to 65 degrees, and the angle made by the dashed line **62** and the direction of the surfaces of the light-transmissive layers **83** and **84** was set to 30 degrees.

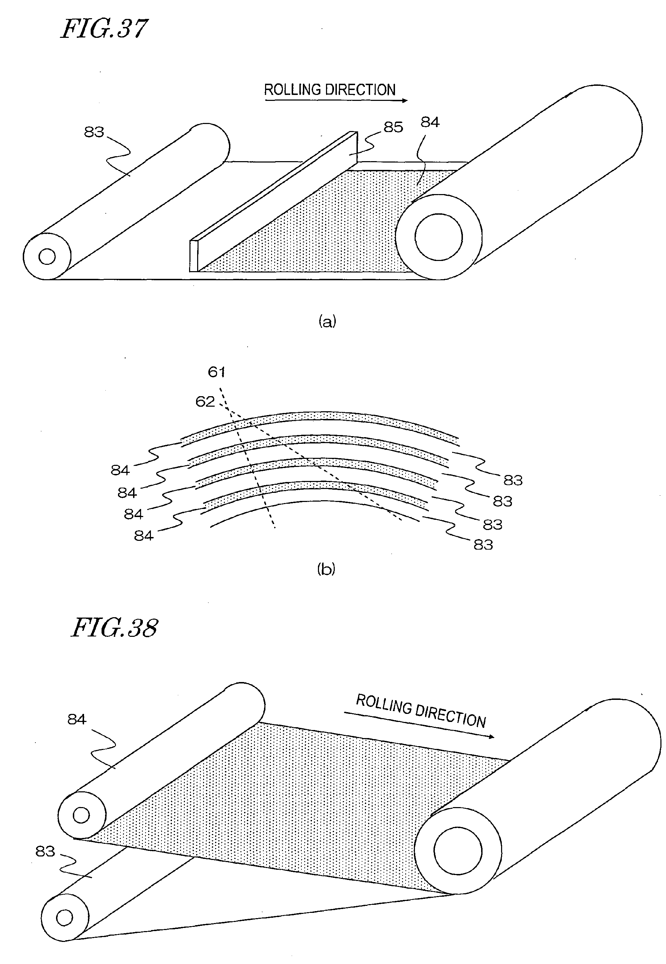

In the case where the light-transmissive layers **83** can be flexibly curved like film substrates formed of a resin material, the light-transmissive layers **83** can be produced more easily by a roll-to-roll process as shown in FIGS. **37(a)** and **(b)** and FIG. **38.**

FIGS. **37(a)** and **(b)** show a first method by the roll-to-roll process.

First, as shown in FIG. **37 (a),** on one surface of a film substrate **83** formed of a light-transmissive flexible material, a resin material **84** having a refractive index lower than that of the substrate **83** is uniformly applied by ejecting the resin from a nozzle **85** using an application device such as a slit coater or the like. Then, the resultant substance is dried and cured, and then rolled up by a roll. As the film substrate **83,** a polyethylene terephthalate (PET) film or an acrylic film is usable, for example. As the resin material having a low refractive index, a resin containing a fluorine-based compound such as Opstar (trade name) produced by JSR or the like is usable, for example. Next, the roll is heated to a temperature equal to or higher than the softening point of the film substrate **84** in an oven or the like, and thus the films are fused together.

Next, as shown in FIG. **37(b),** the laminate obtained as described above is cut, as represented by dashed lines **61** and **62,** obliquely with respect to the surfaces of the substrates **83** and **84.** The cut surfaces are polished when necessary to improve the external appearance. Thus, the sheet laminate **80** shown in FIG. **5** is obtained.

The surfaces of the substrates **83** and **84** are, precisely, curved, but may be approximated to generally planar surfaces when the diameter of the roll is made sufficiently larger than the thickness of the sheet laminate **80** (for example, 6 inches or the like). Even if the surfaces are actually curved, the effect is not specifically different as long as the light can be guided in the material of the film. The curved surfaces can be deformed to planar surfaces when, after being peeled off from the roll, the laminate is pressurized by a press or the like while being heated so as to be a flat plate.

Instead of the films being fused, the roll may be rolled up via layers having adhesiveness (including tackiness). Thus, the roll may be cured so that the layers are not delaminated.

As the tacky or adhesive material, a resin material such as a thermosetting resin, a thermoplastic resin, an ultraviolet-curable resin or the like is usable, for example. It is preferable that the thickness of the tacky or adhesive layers is as small as possible in the range in which the layers have a high light transmissivity, low light scattering characteristics and a sufficient level of strength after being cured.

FIG. **38** shows a second method by the roll-to-roll process.

A film substrate **83** formed of a light-transmissive material such as a polyethylene terephthalate (PET) film, an acrylic film or the like, and a film substrate **84** formed of a fluorine-based compound having a refractive index lower than that of the film substrate **83** such as Neoflon produced by Daikin Industries, Ltd. or the like, are rolled up while being stacked.

Next, this roll is heated to a temperature equal to or higher than the softening point of the film substrate **83** or **84** in an oven or the like, and thus the films are fused together.

. Then, the sheet laminate **80** shown in FIG. **5** is obtained in substantially the same manner as described above. Again, instead of the films being fused, the roll may be rolled up via layers having adhesiveness (including tackiness) and cured so that the layers are not delaminated.

For example, the sheet laminate **80,** produced by the first method of the roll-to-roll process, guides light at an interface between the PET layer having a refractive index of 1.65 and a low refractive index resin layer containing a fluorine-based compound and having a refractive index of 1.4. Namely, the PET layer corresponds to the core of the optical fiber and the low refractive index resin layer corresponds to the cladding. Needless to say, as the refractive index difference between the core and the cladding is larger, the numerical aperture (NA) of the sheet laminate is larger and so the light transmittance is higher, which is preferable. In order to prevent the light leaking from the PET layer from being incident on the adjoining PET layer, it is preferable to stack a light absorbing layer outside the low refractive index resin layer. If the light leaking from the PET layer is incident on the adjoining PET layer, the displayed image may be blurred occasionally. As the light absorbing layer, a PET film containing a coloring agent or the like is usable, for example.

In the above, a structure and method for providing uniform display is described with reference to FIG. **20** and FIG. **21** regarding the liquid crystal display device **200.** Using a similar structure and method, the liquid crystal display device **100a** also provides uniform display.

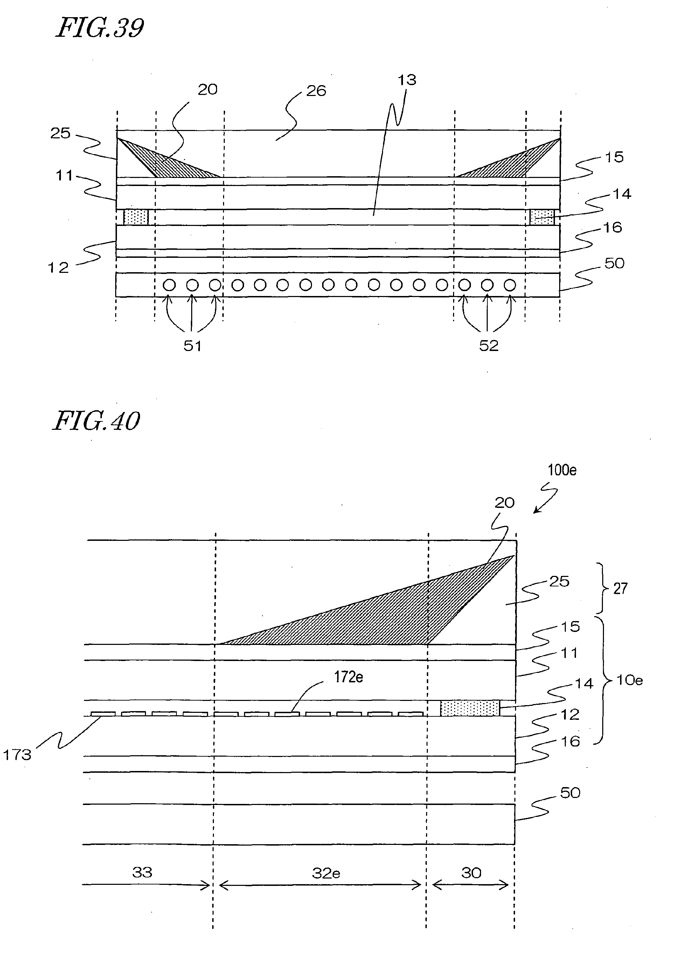

In the liquid crystal display device 100a, among display light, the display light which goes out from the part **32** of the peripheral display region on which the light guide element **20** is disposed is enlarged by the light guide element **20** along the first axis. Therefore, the luminance is decreased in accordance with the ratio of enlargement. In the case where an optical fiber face plate is used as the light guide element, the luminance is decreased by the numerical aperture of the core of the optical fibers and transmission loss in the optical fibers. In this case, the luminance can be uniformized by at least one of method a and method b described above. For example, method b is performed by, as in the backlight device **50** shown in FIG. **39,** lighting cold cathode fluorescent tube groups **51** and **52** disposed in correspondence to the part **32** of the peripheral display region brighter than the other cold cathode fluorescent tubes.

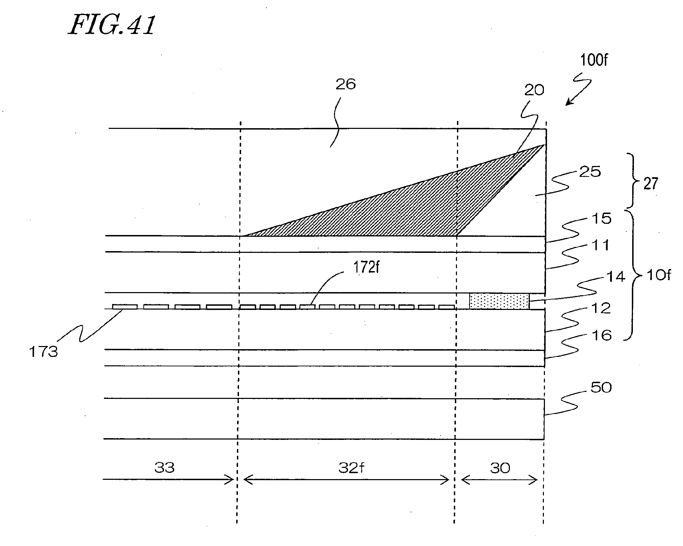

In the liquid crystal display device **100a,** an image formed in the part **32** of the peripheral display region is enlarged. In this case, the image can be uniformized by at least one of method 1 and method 2 described above. An example of uniformizing the image by method 1 will be described with reference to FIG. **40.** FIG. **40** is a cross-sectional view showing a liquid crystal display device **100e** including a liquid crystal display panel **10e** having a constant pixel pitch. As shown in FIG. **40,** in the liquid crystal display panel **10e,** the pitch of pixels **173e** (pixels provided in a central display region **33)** and pixels **172e** (pixels provided in a part **32e** of a peripheral display region) is constant across the entire display region (part **32e** of peripheral display region and central display region **33).** By keeping the pixel pitch constant and compressing the display signal to be supplied to the pixels **172e** arrayed in the part **32e** of the peripheral display region through signal processing, the image can be uniformized. An example of uniformizing the image by method 2 will be described with reference to FIG. **41.** FIG. **41** shows a liquid crystal display device **100f** including a liquid crystal display panel **10f** in this case. As shown in FIG. **41,** in the liquid crystal display panel **10f,** the pitch of pixels **172f** provided in a part **32f** of a peripheral display region is narrower than the pitch of pixels **173** provided in a central display region **33.** By narrowing the pitch of the pixels in the part **32f** of the peripheral display region, the image is uniformized.

As described above, according to the present invention, display having a frame region obscured is realized by providing a light guide element on the viewer's side with respect to the display panel. In a display device including a plurality of display panels, the joint between the display panels can be obscured more easily than in the conventional display device, by providing a light guide element.

## INDUSTRIAL APPLICABILITY

The present invention is preferably usable for various types of direct-viewing type display devices.

## REFERENCE SIGNS LIST

| 10 | Liquid crystal display panel |
| 11 | Counter substrate |
| 12 | TFT substrate |
| 13 | Liquid crystal display layer |
| 14 | Sealing portion |
| 15, 16 | Optical film portion |
| 20 | Light guide element |
| 21 | Incident face |
| 22 | Outgoing face |
| 23 | Side face |
| 25 | Resin layer |
| 26 | Cover |
| 30 | Frame region |
| 31 | Display region |
| 32 | Part of peripheral display region |
| 50 | Backlight device |
| 100a | Liquid crystal display device |

## Claims

1. A direct-viewing type display device, comprising:

at least one display panel having a display region and a frame region formed outside the display region; and
at least one light guide element having an incident face, an outgoing face, and a plurality of light guide portions
formed between the incident face and the outgoing face;
wherein:

the plurality of light guide portions include at least one transparent portion;
the at least one transparent portion has a metal portion provided in at least a part of a side face thereof;
the incident face of the at least one light guide element is disposed so as to overlap a part of a peripheral
display region adjoining the frame region of the at least one display panel along a first axis and so as to be
parallel to a surface of the at least one display panel; and
a distance between the outgoing face and the incident face of the at least one light guide element increases along the first axis from the part of the peripheral display region toward the frame region.

2. The display device of claim 1, wherein the at least one light guide element has a laminate in which a plurality of transparent layers and a plurality of metal layers are stacked.

3. The display device of claim 2, wherein the plurality of metal layers include a metal layer having a thickness of 100 nm or greater and 5 $\mu$m or less.

4. The display device of claim 3, wherein the plurality of metal layers include a metal layer having a thickness of 100 nm or greater and 1 $\mu$m or less.

5. The display device of claim 1, wherein the at least one transparent portion is generally cylindrical, and the side face thereof is covered with the metal portion.

6. The display device of any one of claims 1 through 5, wherein:

   the at least one display panel includes first and second display panels adjoining each other;
   a side face of the second display panel overlaps the frame region of the first display panel such that an angle made by a viewer-side surface of the first display panel and a viewer-side surface of the second display panel is greater than 0° and less than 180°;
   the at least one light guide element includes first and second light guide elements; and
   a volume of the first light guide element is larger than a volume of the second light guide element.

7. The display device of claim 6, wherein an end, on the side of the second display panel, of the outgoing face of the first light guide element abuts on an end, on the side of the first display panel, of the outgoing face of the second light guide element.

8. The display device of claim 6 or 7, wherein the outgoing face of the first light guide element is parallel to the outgoing face of the second light guide element.

9. The display device of any one of claims 6 through 8, wherein the first light guide element and the second light guide element have a triangular prism shape.

10. The display device of claim 9, wherein the first light guide element and the second light guide element have an isosceles triangular prism shape.

11. The display device of claim 10, wherein where the angle made by the viewer-side surface of the first display panel and the viewer-side surface of the second display panel is θ, the first light guide element and the second light guide element have an isosceles triangular prism shape having a vertex angle of θ/2.

12. The display device of claim 6 or 7, wherein the outgoing faces of the first light guide element and the second light guide element are cylindrical surfaces.

13. The display device of any one of claims 6 through 12, further comprising a backlight device on the side opposite from the viewer-side surface of the second display panel, wherein a side face, on the side of the first display panel, of the backlight device is parallel to the viewer-side surface of the first display panel and overlaps the frame region of the first display panel.

14. The display device of any one of claims 6 through 13, further comprising a light-diffusing layer on the outgoing face of the first light guide element or the outgoing face of the second light guide element.

15. The display device of any one of claims 6 through 14, wherein:

   the at least one display panel includes at least three display panels; and
   the at least three display panels are disposed in an annular shape.

*FIG.1*

*FIG.2*

## FIG.3

## FIG.4

*FIG.5*

80

84

83

*FIG.6*

93    93    93
94  /  94  /  94  /  94

90

99    98

*FIG.7*

*FIG.8*

*FIG.9*

*FIG.10*

(a)

(b)

*FIG.11*

*FIG.12*

*FIG.13*

*FIG.14*

*FIG.15*

(a)

(b)

*FIG.16*

*FIG.17*

*FIG.18*

*FIG.19*

*FIG.20*

20a

15a
11a
172a
14a ⟩10a
12a
16a
173a

50a

33a   32a   30a

31a

J2

*FIG.21*

20a

15a
11a
14a  10a
12a
16a

172a

173a

50a

33a

32a

30a

31a

J2

FIG.22

400

417b

410b

420b

420a

417a

72

410a

*FIG.23*

410b

400

420b

72

420a

410a

(a)

400

410b

72

420b

420a

410a

(b)

*FIG.24*

*FIG.25*

*FIG.26*

*FIG.27*

*FIG.28*

*FIG.29*

*FIG.30*

*FIG.31*

*FIG.32*

# FIG.33

*FIG.34*

*FIG.35*

(a)

(b)

*FIG.36*

84 — 83

(a)

61
62
84 — 83
84 — 83
84 — 83
84 — 83
84 — 83

(b)

*FIG.37*

ROLLING DIRECTION

(a)

(b)

*FIG.38*

ROLLING DIRECTION

*FIG.39*

*FIG.40*

*FIG.41*

| **INTERNATIONAL SEARCH REPORT** | | International application No. |
| --- | --- | --- |
| | | PCT/JP2009/006074 |

**A. CLASSIFICATION OF SUBJECT MATTER**
*G09F9/40*(2006.01)i, *G02F1/1333*(2006.01)i, *G02F1/1335*(2006.01)i, *G09F9/00*
(2006.01)i, *H04N5/66*(2006.01)i

According to International Patent Classification (IPC) or to both national classification and IPC

**B. FIELDS SEARCHED**

Minimum documentation searched (classification system followed by classification symbols)
G09F9/40, G02F1/1333, G02F1/1335, G09F9/00, H04N5/66

Documentation searched other than minimum documentation to the extent that such documents are included in the fields searched
Jitsuyo Shinan Koho        1922-1996   Jitsuyo Shinan Toroku Koho   1996-2009
Kokai Jitsuyo Shinan Koho   1971-2009   Toroku Jitsuyo Shinan Koho   1994-2009

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 61-165786 A  (Matsushita Electric Industrial Co., Ltd.), 26 July 1986 (26.07.1986), entire text; all drawings (Family: none) | 1-15 |
| A | JP 9-37194 A  (Mitsubishi Electric Corp.), 07 February 1997 (07.02.1997), entire text; all drawings (Family: none) | 1-15 |
| A | JP 6-43479 A  (Sharp Corp.), 18 February 1994 (18.02.1994), entire text; all drawings (Family: none) | 1-15 |

☒ Further documents are listed in the continuation of Box C.      ☐ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 01 December, 2009 (01.12.09) | 15 December, 2009 (15.12.09) |

| Name and mailing address of the ISA/ | Authorized officer |
| --- | --- |
| Japanese Patent Office | |
| Facsimile No. | Telephone No. |

Form PCT/ISA/210 (second sheet) (April 2007)

**INTERNATIONAL SEARCH REPORT**

| International application No. |
|---|
| PCT/JP2009/006074 |

C (Continuation). DOCUMENTS CONSIDERED TO BE RELEVANT

| Category* | Citation of document, with indication, where appropriate, of the relevant passages | Relevant to claim No. |
|---|---|---|
| A | JP 2004-524551 A (Seamless Display Ltd.), 12 August 2004 (12.08.2004), entire text; all drawings & US 2004/0051944 A1 & GB 28890 D & EP 1337892 A & WO 2002/042838 A1 & AU 1251502 A & CA 2436869 A & IL 156163 D & ZA 200304241 A | 1-15 |
| A | Microfilm of the specification and drawings annexed to the request of Japanese Utility Model Application No. 32161/1989(Laid-open No. 123989/1990) (Stanley Electric Co., Ltd.), 12 October 1990 (12.10.1990), page 6, line 12 to page 7, line 2; fig. 2 (Family: none) | 1-15 |

Form PCT/ISA/210 (continuation of second sheet) (April 2007)

**EP 2 360 662 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 7128652 A
- JP 2000056713 A
- JP 2001005414 A